(19) Europäisches Patentamt / European Patent Office / Office européen des brevets

(11) **EP 2 460 275 B1**

(12) **FASCICULE DE BREVET EUROPEEN**

(45) Date de publication et mention de la délivrance du brevet:
**10.09.2014 Bulletin 2014/37**

(21) Numéro de dépôt: **10754359.7**

(22) Date de dépôt: **28.07.2010**

(51) Int Cl.:
*H03M 3/00* (2006.01)    *H03M 1/10* (2006.01)
*H03M 1/12* (2006.01)

(86) Numéro de dépôt international:
**PCT/FR2010/051603**

(87) Numéro de publication internationale:
**WO 2011/012812 (03.02.2011 Gazette 2011/05)**

(54) **CORRECTION DES DÉFAUTS ANALOGIQUES DANS DES CONVERTISSEURS ANALOGIQUES/NUMÉRIQUES PARALLÈLES, NOTAMMENT POUR DES APPLICATIONS MULTISTANDARDS, RADIO LOGICIELLE ET/OU RADIO-COGNITIVE**

KORREKTUR VON ANALOGDEFEKTEN BEI PARALLELEN ANALOG-DIGITAL-WANDLERN, INSBESONDERE ZUR ANWENDUNG IN MULTISTANDARD-, SOFTWAREDEFINIERTEM UND/ ODER KOGNITIVEM FUNK

CORRECTION OF ANALOG DEFECTS IN PARALLEL ANALOG-TO-DIGITAL CONVERTERS, IN PARTICULAR FOR MULTI-STANDARD, SOFTWARE-DEFINED RADIO AND/OR COGNITIVE RADIO APPLICATIONS

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **30.07.2009 FR 0955351**

(43) Date de publication de la demande:
**06.06.2012 Bulletin 2012/23**

(73) Titulaire: **Groupe des Ecoles de Télécommunications - Ecole Nationale Supérieure des Télécommunications 75634 Paris Cedex 13 (FR)**

(72) Inventeurs:
• **BEYDOUN, Ali**
  **F-86550 Mignaloux Beauvoir (FR)**

• **NGUYEN, Van Tam**
  **F-92160 Antony (FR)**
• **LOUMEAU, Patrick**
  **F-94440 Marolles en Brie (FR)**

(74) Mandataire: **Cabinet Plasseraud 52, rue de la Victoire 75440 Paris Cedex 09 (FR)**

(56) Documents cités:
• **ROBERT D BATTEN ET AL: "Calibration of Parallel Delta-Sigma ADCs", IEEE TRANSACTIONS ON CIRCUITS AND SYSTEMS II: EXPRESS BRIEFS, IEEE SERVICE CENTER, NEW YORK, NY, US, vol. 49, no. 6, 1 juin 2002 (2002-06-01), XP011071590, ISSN: 1057-7130 cité dans la demande**

**Description**

La présente invention a trait au traitement d'un signal issu d'une conversion analogique/numérique.

L'évolution actuelle des systèmes de télécommunications tend à intégrer de plus en plus de services et d'applications (multimédia, Internet, télévision, positionnement GPS, applications WiFi, ou autres) nécessitant le recours à des normes de réception variées. Outre la multiplication de ces normes, l'élargissement des bandes passantes de transmission conduit à la nécessité de concevoir des récepteurs qui s'adaptent à différentes normes, mais aussi qui opèrent sur une large bande. Pour une fonctionnalité multistandard (selon différentes normes), la possibilité de reconfigurer en ligne des récepteurs à l'aide d'une programmation logicielle est particulièrement avantageuse, justifiant pour de tels dispositifs le terme de « radio-logicielle ». De plus, de tels récepteurs permettent d'analyser l'état de la bande fréquentielle en temps réel afin de réaliser une gestion intelligente du spectre. On parle alors d'adaptation « radio-cognitive ».

Pour atteindre de tels objectifs, les signaux reçus doivent être numérisés au plus prés de l'antenne afin de permettre un traitement logiciel et une gestion intelligente du spectre. Dans ce contexte, la mise en parallèle, selon une structure multivoies, de convertisseurs analogique/numérique avec la technique à entrelacement temporel présente une solution prometteuse. Par exemple, un système à quatre voies utilisant des modulateurs sigma-delta innovants avec une interpolation adéquate peut fournir un rapport signal à bruit (ou « SNR ») idéal de 102 dB. De tels modulateurs sigma-delta sont décrits notamment dans les documents FR-08 58632 et FR-08 53213.

Cependant, la présence inévitable d'erreurs analogiques (présence d'offset, disparité des gains sur les différentes voies de la structure multivoies) issues du processus de fabrication limite considérablement les performances attendues de ce type de convertisseur. Par exemple, avec des offsets très faibles (d'un écart type de $2 \times 10^{-6}$), le rapport SNR se dégrade de 30 dB. Une chute de 30 dB du rapport SNR est également observée du fait de la disparité entre les gains avec un écart-type de seulement 0,1%.

Plusieurs solutions ont été proposées pour corriger ces erreurs. Ces solutions se classent suivant les trois approches décrites ci-après.

Une première approche consiste en l'élimination de l'erreur absolue sur chaque voie. Cette technique se base sur l'estimation des valeurs de l'offset et du gain pour chaque modulateur dans le but de les corriger en multipliant le signal en sortie par l'inverse du gain estimé pour la correction du gain et en retranchant l'offset estimé pour la correction de l'offset. Plusieurs méthodes ont été proposées pour atteindre cet objectif.

La première méthode est décrite notamment dans le document :

"Calibration of parallel ΣΔ ADCs", R. Batten, A. Eshraghi, T. Fiez, IEEE transactions on circuits and systems-II analog and digital signal processing, vol.49, no.6, juin 2002, p.390-399.

Cette méthode consiste à utiliser un modulateur sigma-delta numérique en aval du modulateur analogique pour estimer les erreurs et les compenser. Cette méthode effectue la correction en temps différé. L'estimation de l'offset et du gain se fait par le modulateur numérique en connectant l'entrée du modulateur analogique à la masse où à une tension de référence constante. La correction se fait par le réglage de la valeur dans le chemin du retour du modulateur numérique. L'ordre du modulateur numérique doit être plus élevé que celui du modulateur analogique afin de ne pas augmenter le niveau de bruit. Cette solution n'est pas optimale en termes de moyens à déployer et de puissance consommée car elle exige d'ajouter autant de modulateurs numériques que de modulateurs analogiques en plus du traitement numérique.

La deuxième méthode propose la correction de l'offset en temps réel, comme décrit dans le document :

"Digital offset compensation of time-interleaved ADC using random chopper sampling", JE Eklund, F Gustafsson, IEEE ISCAS 2000, Geneva, Switzerland, mai 2000.

Cette méthode consiste à multiplier le signal d'entrée de chaque modulateur par une séquence pseudo-aléatoire {+1,-1} pour le blanchir. Ensuite, à la sortie du modulateur, un calcul de la valeur moyenne sur N points permet d'avoir une estimation de la valeur de l'offset. Finalement, la valeur estimée sera retranchée du signal avant de multiplier ce dernier par la même séquence pseudo-aléatoire pour retrouver le signal utile. Cette deuxième méthode présente quant à elle les problèmes suivants :

- la multiplication par la séquence pseudo-aléatoire s'effectue dans le domaine analogique, ce qui n'est pas très précis ; de plus, cette multiplication analogique ajoute des contraintes sur le premier étage du modulateur sigma-delta,
- le blanchiment du signal à l'entrée du modulateur augmente le niveau de bruit et complique la mise en forme du bruit de quantification par le modulateur lorsque son ordre est faible et le convertisseur analogique/numérique (ou « CAN ») dans la boucle a un faible nombre de bits,

- la multiplication par la même séquence en sortie ne permet pas de récupérer le signal utile si le gain de la fonction de transfert du signal (ou « STF ») du modulateur n'est pas égal à l'unité,
- la correction des erreurs dans la chaîne de réception introduites avant la multiplication par la séquence pseudo-aléatoire à l'entrée du modulateur n'est pas possible.

Une troisième méthode dédiée à la correction de l'erreur de gain absolue dans des modulateurs sigma-delta passe-haut, en temps différé, a été proposée dans le document :

"Advantages of high-pass $\Delta\Sigma$ modulators in interleaved $\Delta\Sigma$ analog to digital converter", V.T. Nguyen ; P. Loumeau ; J.F. Naviner, Circuits and Systems, MWSCAS-2002 (45th Midwest Symposium), Volume 1, 4-7, Page(s) : I - 136 - I - 139, août 2002.

Cette méthode utilise les algorithmes de Moindres Carrés stochastiques, qui présentent une simplicité d'implémentation avantageuse, pour estimer l'inverse du gain sur chaque voie. L'inconvénient de cette méthode toutefois est qu'elle doit s'appliquer en l'absence d'offset sinon l'erreur sur l'estimation de l'inverse du gain est très grande. En règle générale, il est donc préférable, dans le cas des modulateurs passe-bas, d'appliquer une correction d'offset avant d'entamer la correction de l'erreur de gain. De plus, cette méthode nécessite la connaissance de la réponse idéale de l'architecture à entrelacement temporel à un signal de référence en entrée, ce qui présente une difficulté de mise en oeuvre à cause du comportement chaotique des modulateurs sigma-delta.

Une deuxième approche se base sur une égalisation des erreurs sur les différentes voies.

Etant donné que l'apparition des raies spectrales parasites en sortie est due au désappariement entre les erreurs de gain et d'offset des modulateurs sigma-delta, cette deuxième approche vise à égaliser ces erreurs de gain et d'offset.

Dans le but d'égaliser les erreurs sur toute les voies, il a été proposé dans le document EP1401105 une méthode qui consiste à utiliser un convertisseur analogique-numérique supplémentaire en tant que convertisseur de référence. Ensuite, ce convertisseur supplémentaire est connecté en parallèle avec le convertisseur en phase de correction afin d'égaliser son offset et son gain avec ceux du convertisseur de référence. Bien que cette méthode présente l'avantage d'effectuer la correction en temps réel, la correction des offsets ne peut pas être parfaite en raison de la présence des erreurs de gain qui sont incontournables. De plus, le traitement numérique pour égaliser les erreurs de gain est assez complexe.

Pour éviter l'ajout d'un convertisseur supplémentaire pour effectuer la correction de gain en temps réel, il a été proposé de remplacer le convertisseur analogique-numérique supplémentaire par un convertisseur numérique-analogique mono-bit, un générateur de signal {+1,-1} pseudo-aléatoire et bloc numérique implantant l'algorithme des Moindres-Carrés LMS (pour « Least Mean Square ») pour égaliser les gains, dans le document:

"A digital background calibration techniques for time-interleaved anadog-to-digital converters", D. Fu, K.C. Dyer, S.H. Lewis, P.J. Hurst, IEEE Journal of Solid-State Circuits, décembre 1998.
L'inconvénient de cette méthode est que le traitement intervient à l'entrée du modulateur, donc dans le domaine analogique, et qu'elle ne permet pas de supprimer l'offset.

La troisième approche consiste à blanchir les erreurs de gain et d'offset en étalant l'énergie des raies spectrales issues de ces erreurs sur toute la plage fréquentielle. Pour ce faire, il a été proposé l'ajout d'un modulateur supplémentaire à l'architecture à entrelacement temporel avec une technique de sélection aléatoire des voies tout en assurant le bon fonctionnement du convertisseur à entrelacement temporel, dans le document :

"A comparative analysis of parallel delta-sigma ADC architectures", A. Eshraghi et T. Fiez, Circuits and Systems I: Regular Papers, IEEE Transactions on, vol. 51, no. 3, p. 450-458, 2004.

Cette technique nécessite toutefois des ressources supplémentaires de calcul (appelées aussi « surface » nécessaire), dans le convertisseur, en imposant un modulateur supplémentaire. Elle conduit en outre à une diminution du rapport SNR souhaité en augmentant le niveau de bruit, suite au blanchiment des erreurs de gains et d'offset.

Il apparait qu'aucune des techniques présentées ci-avant ne donne réellement satisfaction pour corriger, à la fois, l'offset et les disparités de gains, et ce de façon efficace, sans déployer trop de ressources et sans dégrader significativement le rapport SNR.

La présente invention vient améliorer la situation.

Elle propose à cet effet un procédé de traitement de signal, dans un convertisseur analogique/numérique comportant une architecture multivoies à entrelacement temporel, comme revendiqué à la revendication 1.

Ainsi, la présente invention propose une estimation fine des défauts tels que l'offset et éventuellement la disparité de gain, en vue d'une correction efficace de ceux-ci. Il sera montré dans la description détaillée ci-après l'intérêt majeur que revêt une estimation fine de l'offset notamment. L'invention permet alors de réduire significativement tous les effets indésirables dus aux défauts analogiques. Par exemple, avec des offsets très faibles (d'un écart type de $2 \times 10^{-6}$), le rapport SNR se dégradant habituellement de 30 dB et/ou une chute de 30 dB du rapport SNR étant habituellement observée du fait de la disparité entre les gains avec un écart-type de seulement 0,1% sur les valeurs de gains, la correction numérique que propose la présente invention permet de maintenir le rapport SNR global du système au-delà de 100dB (soit une chute de 2dB environ par rapport à un traitement idéal sans atténuation du rapport SNR).

Dans une réalisation avantageuse, l'invention tire partie d'une architecture multivoies à modulateur sigma-delta dans chaque voie et, en particulier, le filtrage numérique est appliqué dans chaque voie à la fois pour :

- reconstruire un signal utile issu de la conversion analogique/numérique, et
- pour estimer l'erreur d'offset.

L'estimation de l'erreur d'offset est préférentiellement menée, comme on le verra plus loin, par un filtrage passe-bas numérique sélectif. Par exemple, une mesure montre que la largeur de bande du filtre passe-bas (bande passante à -3dB) est égale à $0{,}0025 * f_e$ (où $f_e$ est la fréquence d'échantillonnage du convertisseur).

De façon avantageuse, le filtrage est appliqué par un filtre en peigne dans chaque voie. On vient alors tirer profit de la présence d'un tel filtre habituellement prévu dans un convertisseur présentant une architecture à entrelacement temporel, pour estimer finement l'offset en vue de sa compensation.

La compensation d'offset, elle-même, comporte préférentiellement les étapes :

- appliquer un signal nul en entrée du convertisseur pour obtenir l'offset seul en sortie,
- utiliser le filtrage numérique pour estimer une valeur d'offset pour chaque voie, et
- compenser la valeur estimée de l'offset sur chaque voie.

Dans une réalisation préférentielle décrite en détail plus loin, l'erreur d'offset est estimée à une précision inférieure à $10^{-(0.3n+1.9)}$, où $n$ est la résolution, en nombre de bits, du convertisseur. On montre plus loin qu'une compensation d'une erreur d'offset estimée à cette précision limite une perte de rapport signal à bruit inférieure à 3 dB, dans un exemple de réalisation.

La présente invention prévoit en outre, dans une réalisation avantageuse, une égalisation de gains entre différentes voies du convertisseur. Avantageusement, le filtrage numérique précité est appliqué en outre pour une égalisation de gains entre les différentes voies de l'architecture multivoies, après compensation de l'offset.

Dans une réalisation, on procède aux étapes suivantes :

- on applique un même signal, constant, à chaque voie,
- on récupère un signal de sortie correspondant à un produit de ce même signal par un gain propre à chaque voie,
- on compare le produit de chaque voie au produit d'une voie de référence pour en déduire, pour chaque voie, l'estimation d'un poids d'égalisation de gain par rapport à la voie de référence.

L'estimation du poids pour une voie est menée en appliquant préférentiellement un traitement itératif, au sens des moindres carrés moyens, selon une relation du type $\hat{w}_i[n+1] = \hat{w}_i[n] + \mu f_i[n]$, où :

- $\hat{w}_i[n+1]$ et $\hat{w}_i[n]$ sont les estimations du poids pour une voie $i$, aux itérations respectives n+1 et n,
- $\mu$ est une constante,
- $f_i[n]$ est le produit :

  • entre la différence des signaux de sortie de la voie de référence et de la voie $i$ et le signe du signal de sortie de la voie $i$,
  • ou entre le signal de sortie de la voie $i$ et le signe de la différence des signaux de sortie de la voie de référence et de la voie $i$,
  • ou entre le signal de sortie de la voie $i$ et la différence des signaux de sortie de la voie de référence et de la voie $i$,
  • ou entre le signe du signal de sortie de la voie $i$ et le signe de la différence des signaux de sortie de la voie de référence et de la voie $i$.

Un traitement avantageux parmi ceux énoncés suit en particulier une relation du type :

$$\hat{w}_i[n+1] = \hat{w}_i[n] + \mu(y_{ref}[n] - y_i[n]) \times \text{sgn}(y_i[n]), \text{ où :}$$

- $y_{ref}[n]$ et $y_i[n]$ sont les signaux de sortie respectivement de la voie de référence et de la voie $i$, et
- la notation sgn(x) désigne le signe du réel x.

Dans une réalisation avantageuse, le poids d'égalisation est estimé à une précision inférieure à $10^{-(0.34n-0.65)}$, où $n$ est la résolution, en nombre de bits, du convertisseur. La constante $\mu$ précitée est préférentiellement choisie pour optimiser une vitesse de convergence du traitement itératif et atteindre cette précision. Dans un exemple de réalisation décrit plus loin, une valeur de constante $\mu$ égale à 1 s'est avérée satisfaisante.

Le nombre total d'itérations du traitement est choisi en fonction de la constante $\mu$. Dans l'exemple de réalisation précité, un nombre avantageux est compris entre 15 et 20, pour une valeur $\mu = 1$.

Dans cet exemple de réalisation, une égalisation de gains basée sur une estimation des poids à la précision précitée, inférieure à $10^{-(0.34n-0.65)}$, limite une perte de rapport signal à bruit inférieure à 3 dB.

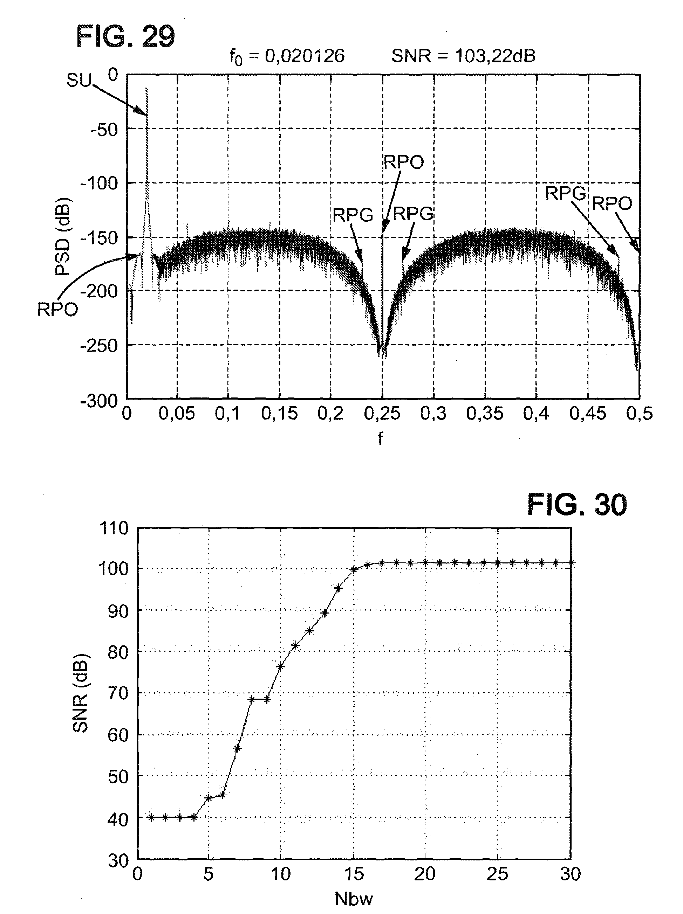

Les valeurs de poids à estimer sont préférentiellement codées sur un nombre de bits compris entre n+1 et n+4, où $n$ est la résolution, en nombre de bits, du convertisseur, comme on le verra dans un exemple de réalisation décrit plus loin en référence aux figures 30 à 33.

La présente invention permet alors d'atteindre notamment les avantages suivants :

- compenser la valeur de l'offset de chaque modulateur dans le domaine numérique contrairement à d'autres solutions qui visent à corriger seulement l'effet de désappariement entre les offsets des différents modulateurs,
- égaliser les erreurs de gain des modulateurs sigma-delta par rapport à un modulateur dans l'architecture sans avoir besoin d'ajouter un modulateur supplémentaire,
- aucune nécessité d'un signal de référence,
- une bonne précision avec un temps de convergence très court pour l'estimation et la correction des défauts.

Par ailleurs, comme on le verra plus loin, la mise en oeuvre de l'invention ne fait éventuellement intervenir, dans un mode de réalisation, qu'un accumulateur (pour une adition) ajouté sur chaque voie en plus des ressources matérielles existant déjà pour la reconstruction numérique du signal utile.

En effet, dans une réalisation avantageuse, l'estimation des valeurs d'offsets ne nécessite aucune ressource matérielle supplémentaire par rapport à la plupart des structures existantes. Comme on le verra plus loin, la mise en oeuvre de l'invention utilise les filtres numériques habituellement dédiés déjà à la reconstruction numérique du signal utile.

Par ailleurs, l'égalisation des gains ne nécessite ni un signal de référence, ni un modulateur supplémentaire. En effet, un modulateur dans l'architecture, sert comme modulateur de référence pour les autres modulateurs, de façon avantageuse.

Le type de convertisseur au sens de l'invention peut avantageusement être mis en oeuvre dans des applications radio reconfigurables permettant d'opérer selon plusieurs standards et plusieurs applications (dans des réseaux GSM, UMTS, WiMAx ou autres, ou encore en technique de positionnement GPS) et les applications radio-cognitive (modulation OFDMA large bande, typiquement) qui ont des largeurs de bandes de fonctionnement différentes. Il peut être également utilisé dans d'autres systèmes d'acquisition de données nécessitant l'augmentation de la bande de fonctionnement du convertisseur.

La présente invention vise aussi le convertisseur analogique/numérique comportant une architecture multivoies à entrelacement temporel, comme revendiqué à la revendication 14.

Avantageusement, le convertisseur comporte en outre des moyens d'égalisation de gain des différentes voies, et le filtre numérique est appliqué en outre pour estimer une égalisation de gains entre les différentes voies de l'architecture multivoies, après compensation de l'offset.

La présente invention vise aussi un programme informatique comportant des instructions pour la mise en oeuvre du procédé selon l'invention, lorsque ce programme est exécuté par un processeur, notamment d'un convertisseur au sens de l'invention.

D'autres caractéristiques et avantages de l'invention apparaîtront à l'examen de la description détaillée ci-après, et des dessins annexés sur lesquels :

- la figure 1 illustre une architecture à entrelacement temporel présentant des erreurs de gain et d'offset des modulateurs,
- la figure 2 représente un exemple de densité spectrale du signal en sortie de l'architecture à entrelacement temporel dans un cas idéal, l'échelle en abscisse étant en fréquence relative (f = F/Fe) par rapport à la fréquence d'échantillonnage Fe,
- la figure 3 représente la densité spectrale du signal en sortie de l'architecture à entrelacement temporel avec un offset identiques à tous les modulateurs,
- la figure 4 illustre l'effet du désappariement des offsets sur le spectre du signal utile en sortie (pour quatre voies dans l'exemple représenté),

- la figure 5 illustre la densité spectrale du signal en sortie avec un offset différent sur tous les modulateurs,
- la figure 6 illustre la variation du rapport signal sur bruit (SNR) en fonction de l'écart-type des valeurs d'offset appliquées sur les voies de l'architecture à entrelacement temporel,
- la figure 7 montre un histogramme des rapports signal à bruit (SNR) obtenus avec 500 tirages, avec un offset aléatoire d'écart-type de $\sigma_o = 2 \times 10^{-6}$,
- la figure 8 montre la variation du rapport SNR en fonction de la précision sur la valeur estimée de l'offset de chaque voie,
- la figure 9 représente la densité spectrale du signal en sortie du convertisseur avec une erreur de gain et d'offset aléatoire, gaussienne, sur chaque voie,
- la figure 10 représente la densité spectrale du signal en sortie d'un modulateur DS et la réponse fréquentielle du filtre en peigne RF,
- la figure 11a montre l'erreur d'estimation d'offset, la figure 11b montrant en particulier la stabilisation de l'erreur après quelques coups d'horloge (moins d'une dizaine), et la figure 11c montre la fluctuation de l'erreur (autour de $10^{-7}$ néanmoins) après stabilisation,
- la figure 12 montre l'erreur d'estimation $Er$ et $Erm$ avec deux valeurs d'écart-type $\sigma_o = 0.002$ et $\sigma_o = 0.2$, pour différentes itérations,
- la figure 13 montre la densité spectrale du signal en sortie avec les erreurs d'offset non compensées,
- la figure 14 montre la densité spectrale du signal en sortie après correction des erreurs d'offset, dans le même exemple de réalisation que la figure 13,
- la figure 15 montre l'effet du désappariement des gains sur le spectre du signal utile en sortie,
- la figure 16 montre la densité spectrale du signal en sortie avec disparité des gains sur les voies,
- les figures 17a et 17b illustrent les variations (respectivement grossière et fine) du rapport SNR en fonction de la valeur de l'écart-type de l'erreur de gain,
- la figure 18 montre un histogramme des rapports SNR obtenus avec 500 tirages, pour un gain aléatoire d'écart-type $\sigma_g = 10^{-4}$,
- la figure 19 montre la variation du rapport SNR en fonction de la précision sur la valeur estimée de gain de chaque voie,
- la figure 20 montre un schéma fonctionnel pour l'égalisation des gains des différentes voies dans l'architecture à entrelacement temporel,
- les figures 21a et 21b illustre l'estimation du poids $w_2$ avec différentes valeurs de pas de convergence $\mu$, avec une limitation de l'échelle d'abscisse à $0 \leq n \leq 100$ pour la figure 21b,
- la figure 22 montre la variation de l'erreur d'estimation du poids $w_2$ avec différentes valeurs du pas de convergence $\mu$,
- la figure 23 montre le maximum de l'erreur d'estimation du poids $w_2$ en fonction du pas $\mu$,
- la figure 24 montre la convergence de l'estimation des poids w en fonction du temps pour un pas tel que $\mu = 1$,
- la figure 25 illustre la convergence du rapport SNR en fonction du temps d'estimation des valeurs de poids $w$,
- la figure 26 illustre la densité spectrale du signal en sortie après l'égalisation des erreurs de gain,
- la figure 27 illustre la densité spectrale du signal en sortie en tenant compte d'erreurs de gain et d'offset à la fois,
- la figure 28 montre la convergence des poids w en fonction du temps pour un pas de convergence $\mu = 1$,
- la figure 29 illustre la densité spectrale du signal en sortie après correction des erreurs de gain et d'offset,
- la figure 30 montre l'évolution du rapport SNR en fonction du nombre de bits de quantification des valeurs de poids $w$,
- la figure 31 montre la convergence des poids w en fonction du temps avec $\mu = 1$ pour différentes valeurs du nombre $Nbw$,
- la figure 32 montre l'erreur d'estimation des valeurs de poids $w$ pour différentes valeurs du nombre $Nbw$,
- la figure 33 montre la densité spectrale en sortie avec égalisation du gain par les poids $w$ pour différentes valeurs du nombre $Nbw$,
- la figure 34 illustre les principales étapes d'un procédé, dans un exemple de réalisation au sens de la présente invention,
- la figure 35 illustre les nombres d'itérations $Nth$ et $Ndiff$ prévus pour une convergence du traitement itératif SD-LMS pour l'estimation des poids, respectivement avec un calcul théorique et un calcul de la différence de deux estimations successives,
- la figure 36 illustre le temps de convergence obtenu avec un filtre dont la fonction de transfert est de type $(1 - z^{Lf})$ avec $Lf = 3$.

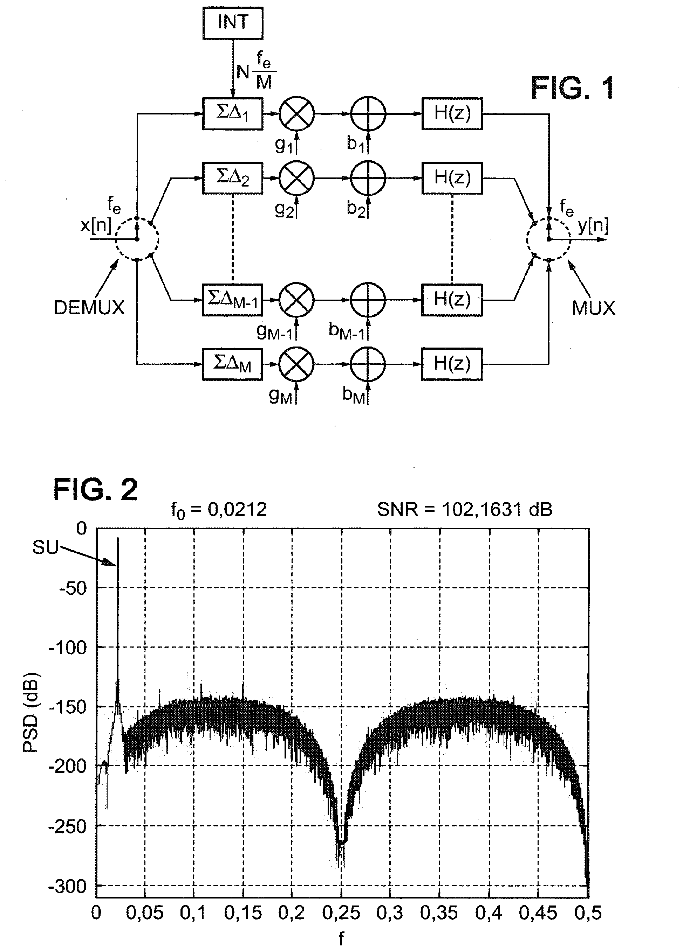

On se réfère tout d'abord à la figure 1 représentant l'architecture à entrelacement temporel d'un convertisseur analogique/numérique sur laquelle :

- un démultiplexeur analogique DEMUX distribue le signal d'entrée entre les $M$ modulateurs sigma-delta identiques en parallèle (référencés $\Sigma\Delta_1,...,\Sigma\Delta_M$),

- un interpolateur INT d'ordre *N* permet d'insérer *N* - 1 zéros entre deux échantillons successifs du signal,

- un modulateur sigma-delta $\Sigma\Delta_i$ dans chaque voie *i* effectue la mise en forme du bruit de quantification,

- un filtre numérique *H(z)* élimine le bruit de quantification, en dehors de la bande utile, et

- un multiplexeur numérique MUX reconstruit le signal numérisé en sortie.

Une telle architecture présente quatre paramètres importants :

- l'architecture du modulateur sigma-delta utilisé et son ordre (*P*),

- le nombre de voies mises en parallèle (*M*),

- le taux d'interpolation (*N*),

- la fréquence d'opération des modulateurs (*$f_{op}$* qui se définit comme égale à *(N/M).$f_e$* où *$f_e$* est la fréquence d'échantillonnage du convertisseur).

Les différentes erreurs analogiques (erreurs sur les valeurs nominales des composants, gain fini des amplificateurs, ou autres) introduites lors du processus de fabrication d'une telle structure se répercutent au niveau du modulateur sigma-delta sous forme d'une erreur de gain et d'un décalage en tension sur le signal en sortie de chaque voie dans l'architecture à entrelacement temporel.

De telles erreurs limitent considérablement la performance des architectures parallèles à entrelacement temporel. En effet, le désappariement entre les valeurs d'offset se manifeste sur le spectre du signal utile en sortie par des raies spectrales situées aux fréquences normalisées $\dfrac{k}{M}$ où *k* est un entier. De plus, le décalage en tension, que ce soit dans un seul modulateur ou dans une architecture parallèle, peut brouiller l'information utile présente à la fréquence nulle. Ce décalage en tension entraîne une chute considérable du rapport signal sur bruit (SNR) du convertisseur même si il est identique pour tous les modulateurs.

En outre, le désappariement entre les valeurs de gains crée dans le spectre du signal en sortie des répliques du signal utile toutes les $\dfrac{k}{M}$ fréquences. Ces répliques indésirables du signal utile entraînent une chute du rapport SNR à la sortie du convertisseur.

Il est donc proposé d'estimer finement et de corriger ces erreurs pour pouvoir maintenir la performance souhaitée par l'architecture parallèle à entrelacement temporel. Dans ce but, il est mené les étapes visant à :

- compenser la valeur de l'offset à la sortie de chaque modulateur, et
- égaliser les gains des différentes voies.

A titre d'exemple purement illustratif et sans perte de généralité, il est décrit ci-après le cas d'une architecture parallèle composée de 4 voies (*M*=4) avec un taux d'interpolation à l'entrée des modulateurs de 80 (*N*=80). L'ordre des modulateurs sigma-delta utilisé est égal à 4 (*P*=4). Le filtre numérique *H(z)* utilisé est un filtre en peigne d'ordre 6. Le signal en entrée est un signal sinusoïdal d'amplitude normalisée de 0,6 et de fréquence normalisée $f_0$ = 0,02 (donc de fréquence absolue 0,02.$f_e$). La densité spectrale du signal utile SU, en sortie, en l'absence des erreurs, est présentée sur la figure 2. Le rapport signal sur bruit (SNR) estimé dans ce cas idéal est égal à 102 dB.

On décrit ci-après l'influence des erreurs d'offset.

Le décalage en tension (ou « offset ») qu'introduisent les modulateurs sigma-delta sur chaque voie provoque une forte chute du rapport SNR et limite les performances du convertisseur analogique numérique à entrelacement temporel. Pour illustrer cet effet, les deux cas suivants sont distingués ci-après :

- le cas d'un offset identique sur tous les modulateurs, et
- le cas d'offsets différents selon les modulateurs.

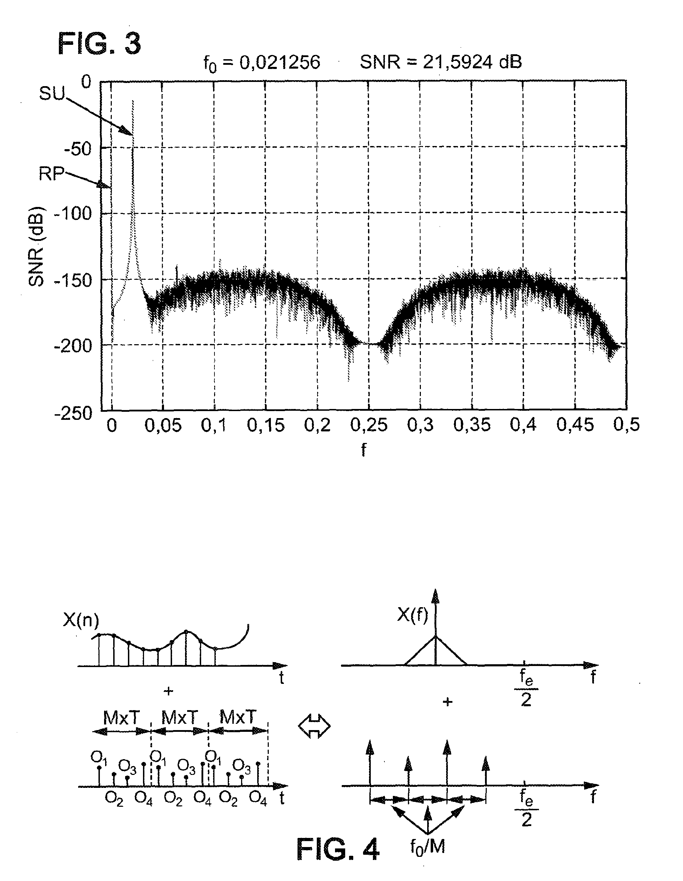

Dans le premier cas, la valeur normalisée de l'offset introduit par rapport à la tension de référence est égale à $4,11 \times 10^{-4}$, dans un exemple de simulation. La figure 3 présente la densité spectrale du signal obtenu en sortie, avec ce type d'erreur. Il apparaît une raie spectrale parasite RP à la fréquence nulle de même amplitude que celle du signal utile, introduisant une chute du rapport SNR de 80 dB.

L'offset identique à toutes les voies n'introduit aucune distorsion sur le signal utile. Cependant, l'information utile, à la fréquence nulle, est erronée, ce qui introduit une grande source d'erreur sur le traitement numérique qui suit le convertisseur (en termes de seuillage, de modulation, etc.).

Bien que ce premier cas ne soit pas très réaliste, sa simulation est présentée ici pour montrer qu'une compensation de l'offset est déjà utile, même si l'offset est identique pour tous les modulateurs.

Le deuxième cas d'un offset différent sur tous les modulateurs est plus réaliste. Le désappariement entre les offsets des différents modulateurs se répercute sous forme de raies spectrales dans le spectre du signal utile en sortie. Ce phénomène est mis en évidence sur la figure 4 dans les domaines temporel (à gauche) et fréquentiel (à droite). Le multiplexage cyclique en sortie de l'architecture à entrelacement temporel ajoute au signal utile un signal périodique formé par les différents offset $O_i$. Ce signal est périodique de période $M$ (avec ici $M=4$), ce qui introduit dans le domaine fréquentiel des raies spectrales situées aux fréquences $\left.\dfrac{kf_e}{M}\right|_{k=0\ldots M-1}$ (donc, dans l'exemple décrit, quatre raies espacées de $f_e/4$ comme représenté).

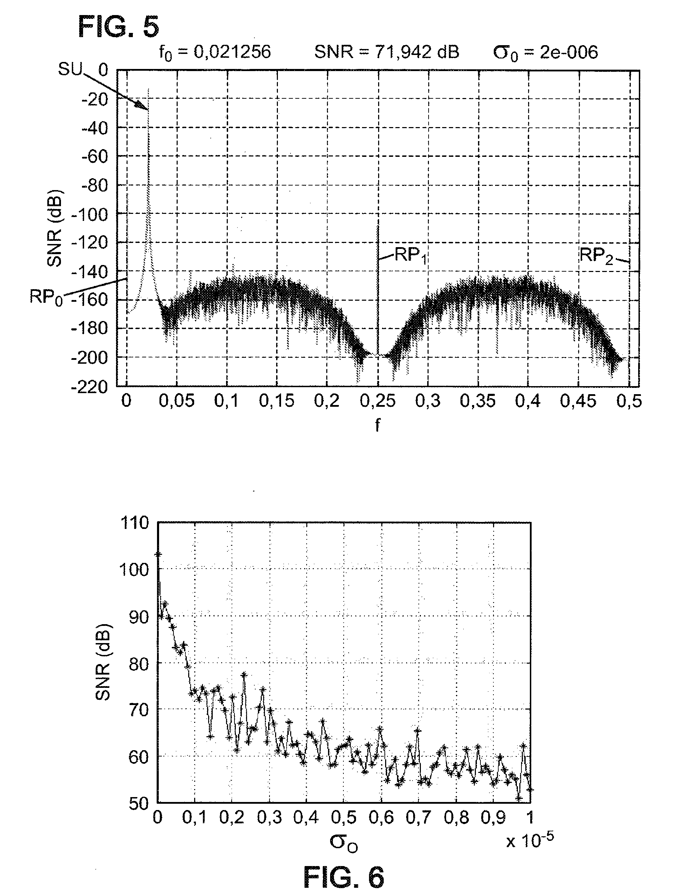

La figure 5 présente la densité spectrale du signal en sortie en considérant des offsets différents, normalisés par rapport à la tension de référence, générés par un signal aléatoire de distribution gaussienne, de moyenne nulle et d'écart-type $\sigma_o = 2 \times 10^{-6}$ ($N(0,\sigma_o)$). Seules sont représentées ici les trois premières raies parasites $RP_0$ (à la fréquence nulle), $RP_1$ (à la fréquence $f_e/4$) et $RP_2$ (à la fréquences $f_e/2$), une quatrième raie étant située à la fréquence $3f_e/4$. On observe en particulier une amplitude variable des raies, fonction de l'écart-type $\sigma_o$.

Avec un écart-type de cette valeur de $2.10^{-6}$, on peut déjà noter sur la figure 5 une chute du rapport SNR significative, de l'ordre de 30 dB. Pour déterminer l'ordre de grandeur du désappariement entre les offsets permettant de maintenir le rapport SNR désiré, le rapport SNR a été calculé en fonction de l'écart-type $\sigma_o$ de l'offset ajouté sur chaque voie. Le résultat obtenu est illustré sur la figure 6. La courbe obtenue montre que l'architecture est très sensible aux erreurs d'offset. Une erreur de l'ordre de $10^{-5}$ peut engendrer une chute du rapport SNR de 50 dB.

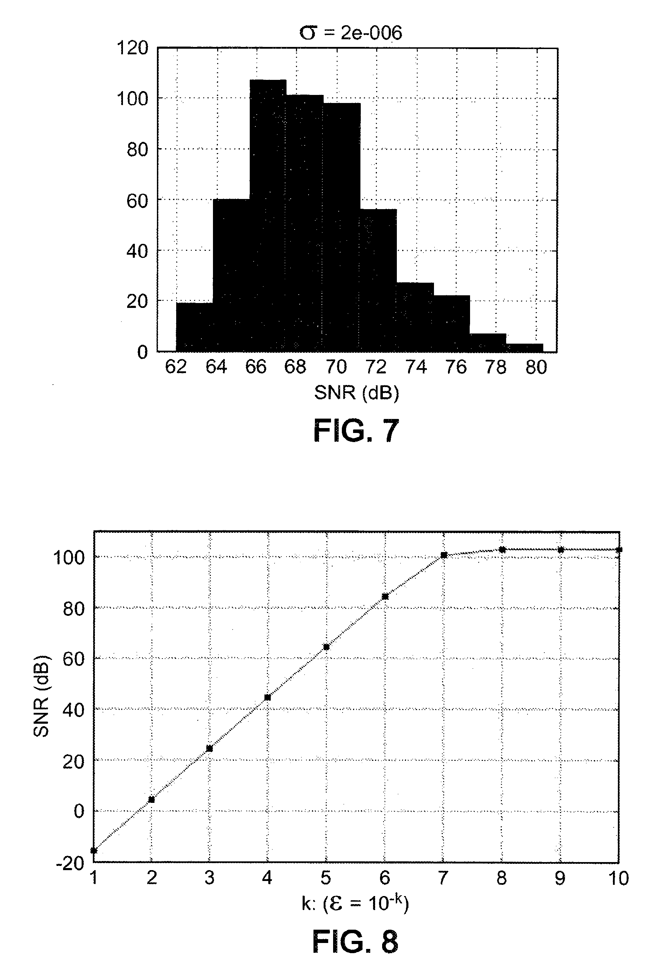

Pour déterminer l'intervalle de variation du rapport SNR, des simulations de Monte-Carlo de 500 tirages en considérant des offsets aléatoires de distribution gaussienne $N(0, \sigma_o)$ ont été menées avec un écart-type $\sigma_o = 2 \times 10^{-6}$. La figure 7 montre à titre purement illustratif l'histogramme des valeurs du rapport SNR obtenues. Une chute moyenne du rapport SNR de 30 dB est notable avec un écart-type de 4 dB.

En se basant sur ces résultats, on retiendra en particulier qu'une faible erreur d'appariement entre les offsets peut aboutir à une perte de 30 dB du rapport SNR souhaité. Il est donc préférable de compenser l'offset sur chaque voie, le plus précisément possible selon le rapport SNR souhaité. A cet effet, il faut estimer finement la valeur de l'offset, puis la retrancher du signal en sortie de chaque modulateur.

Avant de procéder à la phase d'estimation, il est préférable de déterminer d'abord la précision souhaitée sur la valeur estimée. Pour ce faire, le rapport SNR est calculé en introduisant une erreur relative sur la valeur estimée de l'offset définie par :

$$valeur\_estim\acute{e}e = valeur\_th\acute{e}orique \times (1 + \varepsilon)$$

où $\varepsilon$ est l'erreur relative entre la valeur estimée et la valeur théorique de l'offset.

La figure 8 présente l'évolution du rapport SNR en fonction de l'erreur relative $\varepsilon$. Il apparaît un plateau à partir d'une précision de l'ordre de $10^{-7}$. Une telle précision alors est préférable pour assurer une compensation de l'offset et pouvoir maintenir le rapport SNR théorique prévu par l'architecture à entrelacement temporel.

En effet, sur la figure 8, une évolution du rapport SNR est notable, sensiblement linéaire en fonction de la précision, avant d'atteindre la saturation quand l'amplitude des raies parasites, générées par le désappariement des offsets, diminue jusqu'au niveau du bruit de quantification.

On retiendra ici que, dans la partie linéaire, on peut déduire, entre le rapport SNR et la précision, une relation du type $SNR = 20 \times k - 36$, de sorte que la précision sur l'estimation d'offset s'écrit :

$$pr\acute{e}cision = 10^{-k} = 10^{-\left(\frac{SNR+36}{20}\right)}$$

Etant donné que le rapport SNR, en fonction du nombre n de bits équivalents du convertisseur (résolution du convertisseur), est donné par $SNR = 6,02.n + 1,76$, la précision sur les valeurs estimées de l'offset s'exprime par :

$$précision = 10^{-k} = 10^{-(0,3.n+1,9)}$$

Dans les exemples de réalisation décrits ci-après, la résolution n du convertisseur est, à titre d'exemple, égale à 16 (n=16).

La correction que propose la présente invention peut se décrire comme suit.

Le signal en sortie du modulateur sigma-delta, en tenant compte des erreurs de gain et d'offset, s'exprime par :

$$y[n] = \left(x(n-M) + \left(z^{-1}NTF(z)\right) * e[n]\right) \times g + O$$

où :

- $e[n]$ est le bruit de quantification inévitablement généré par la conversion analogique/numérique,
- $NTF(z)$ est une fonction de mise en forme du bruit,
- $O$ désigne l'offset,
- $g$ désigne le gain.

Si l'entrée du modulateur est connectée à la masse, le signal en sortie s'exprime par :

$$y[n] = \left(\left(z^{-1}NTF(z)\right) * e[n]\right) \times g + O$$

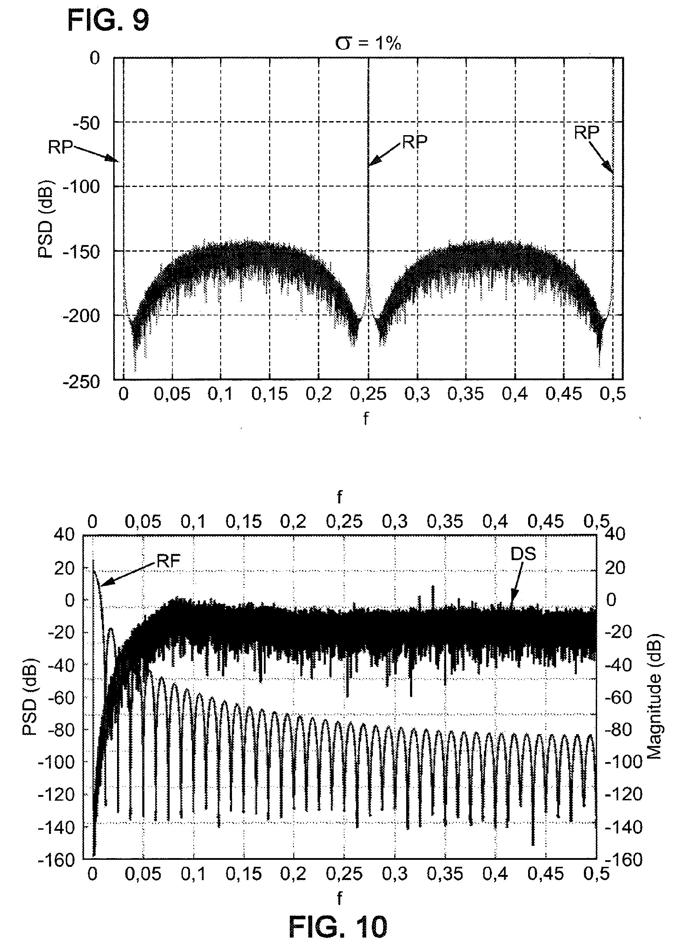

Ainsi, en l'absence de signal utile, le problème des raies spectrales sur le spectre en sortie engendré par le désappariement des gains entre les différents modulateurs ne se retrouve plus. La figure 9 montre la densité spectrale en sortie, en considérant des erreurs de gain et d'offset aléatoires, de distribution gaussienne N(0,1%). Les raies RP dues aux désappariements entre les offsets apparaissent alors indépendamment du signal utile.

Le signal, en sortie du modulateur, est composé de l'offset plus un bruit de quantification supposé blanc et mis en forme par le modulateur. L'estimation de la valeur de l'offset à partir du signal en sortie du modulateur peut donc se faire par un estimateur connu, au sens des Moindres-Carrés, qui s'exprime par :

$$\hat{O} = \frac{1}{Nech} \sum_{i=0}^{Nech-1} y(i)$$

La notation $\hat{O}$ désigne donc l'estimation de l'offset, basée sur un nombre *Nech* de valeurs du signal de sortie $y(i)$. La mise en oeuvre de cet estimateur ne nécessite qu'un accumulateur pour additionner les *Nech* données et une opération de décalage pour effectuer la division par le nombre *Nech* si ce nombre est une puissance de 2. La variance de la valeur estimée est donnée par :

$$\sigma_{\hat{O}}^{2} = \frac{\sigma_{y}^{2}}{Nech}$$

Comme la puissance de bruit présente dans le signal est assez grande, le nombre *Nech* doit être élevé pour atteindre une précision de $10^{-7}$ sur la valeur estimée. Il a pu être vérifié par simulation sur $2^{18}$ échantillons que la précision maximale atteinte est de $5 \times 10^{-6}$.

Pour améliorer la précision sur la valeur estimée de l'offset, il est proposé, dans une réalisation particulièrement avantageuse, de profiter de la présence du filtre en peigne présent dans chaque voie (dédié habituellement à la reconstruction numérique du signal utile), pour diminuer la puissance de bruit présente dans le signal. La figure 10 montre la densité spectrale DS du signal en sortie du modulateur et la réponse fréquentielle RF du filtre en peigne. Il est notable que le filtre en peigne permet de récupérer la valeur de l'offset situé à la fréquence nulle et d'assurer une forte atténuation du bruit (en particulier du bruit de quantification), présent dans le signal et situé dans les plus hautes fréquences.

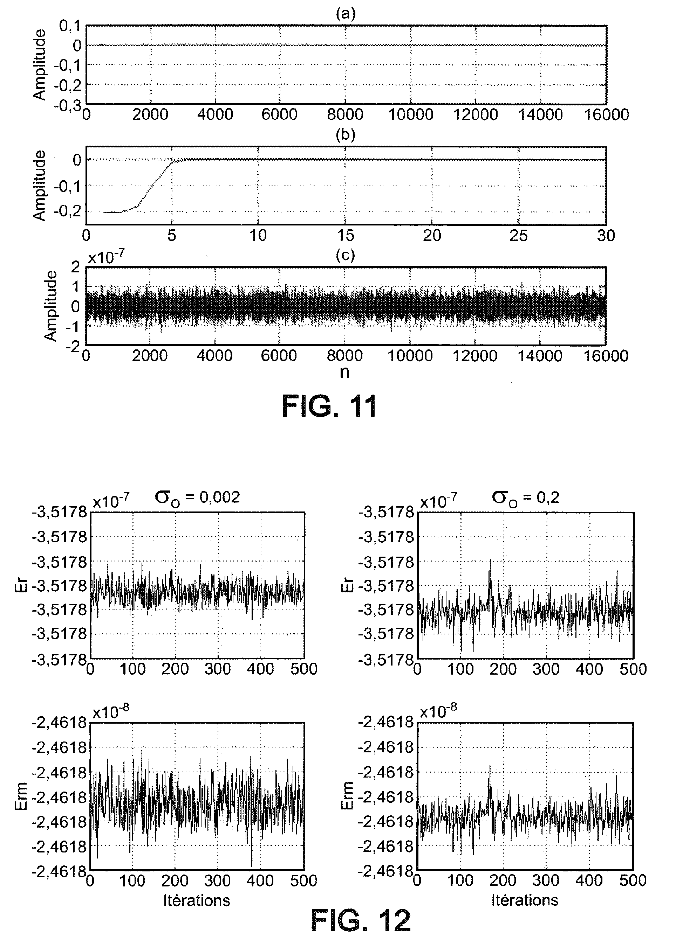

Pour déterminer la précision de la valeur estimée d'offset, l'erreur entre la sortie du filtre en peigne et la valeur théorique de l'offset a été calculée et le résultat obtenu est illustré sur les figures 11a à 11c. Une précision de $10^{-7}$ est avantageusement atteinte (figure 11c) après un traitement ne comportant que 10 opérations simples au plus (6 opérations plus exactement, dans l'exemple représenté), correspondant donc à seulement 10 coups d'horloge d'un processeur (figure 11b illustrant les premiers coups d'horloge avec $0 \leq n \leq 30$). La précision atteinte ici est suffisante pour assurer une bonne correction de l'offset. On indique par ailleurs qu'il est possible aussi, pour améliorer encore la précision, d'utiliser l'estimateur classique d'une valeur constante noyée dans le bruit au sens des Moindres-Carrés à la sortie du filtre en peigne.

Afin de valider la précision obtenue avec d'autres valeurs d'offset, d'autres simulations ont été menées en faisant varier la valeur de l'écart-type $\sigma_o$ dans l'intervalle [0...20%]. Pour chaque valeur de l'écart-type $\sigma_o$, des simulations de Monte-Carlo ont été effectuées sur 500 tirages. Pour chaque tirage, il a été calculé :

- l'erreur maximale *Er* entre l'offset théorique et la sortie du filtre en peigne sur toutes les voies de l'architecture à entrelacement temporel, telle que :

$$Er = \max\left(\left(offset_i - Sortie\_filtre_i\right)\big|_{i=1\ldots M}\right)$$

- l'erreur maximale *Erm* entre l'offset théorique et l'offset estimé à partir de l'estimateur au sens des Moindres-Carrés appliqués à la sortie du filtre en peigne sur toutes les voies de l'architecture à entrelacement temporel, telle que :

$$Erm = \max\left[\left(Offset_i - \frac{1}{Nech}\sum_{k=1}^{Nech} Sortie\_filtre_i(k)\right)\bigg|_{i=1\ldots M}\right]$$

La figure 12 présente à titre d'exemple les valeurs des erreurs *Er* et *Erm* obtenues avec les écart-type $\sigma_o$ =0,002 (à gauche de la figure) et $\sigma_o$ =0,2 (à droite de la figure), en fonction du nombre d'itérations implémentées.

Cette figure montre que :

- l'estimateur au sens des Moindres-Carrés permet d'améliorer légèrement la précision : avec *Nech* =100, la précision, précédemment de l'ordre $10^{-7}$, devient de l'ordre de $10^{-8}$, de sorte que l'amélioration de la précision ne diminue que légèrement, finalement, l'amplitude des raies spectrales parasites ; en particulier, à partir d'une précision de $10^{-8}$, il ne peut pas vraiment être attendu une grande amélioration du rapport SNR (comme illustré précédemment en référence à la figure 8),
- l'erreur d'estimation ne dépend pas, en réalité, de la valeur de l'offset, mais de la réponse fréquentielle RF du filtre en peigne.

Ces résultats montent que l'estimation de l'offset avec un filtre en peigne est suffisante pour assurer une bonne correction de l'offset. Afin d'illustrer l'efficacité de cette estimation, les valeurs d'offsets suivantes [-0,202; 0,717; 0,765; 0,1832]$\times 10^{-4}$ ont été ajoutées dans les différentes voies de l'architecture à entrelacement temporel, dans une simulation.

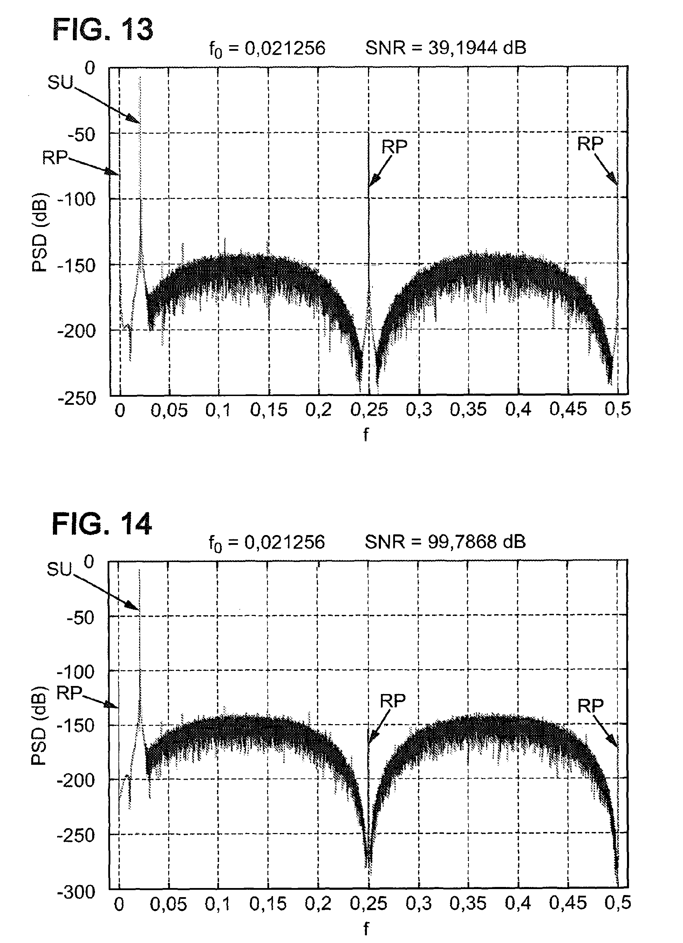

Les figures 13 et 14 présentent la densité spectrale du signal en sortie respectivement avant et après la correction de l'offset sur chaque voie. Comme représenté sur la figure 14, la compensation de l'offset a permis d'atteindre une forte diminution de l'amplitude des raies spectrales parasites RP pratiquement jusqu'au niveau du bruit de quantification. Le rapport SNR est ainsi amélioré de 60 dB, grâce à la correction au sens de l'invention. Le rapport SNR obtenu après la correction ne présente, en effet, qu'une légère atténuation de 2 dB par rapport au rapport SNR idéal.

Ainsi, la technique de compensation d'offset au sens de l'invention, par rapport aux méthodes de l'art antérieur, présente les avantages suivants :

- elle assure une bonne précision, malgré la présence des erreurs de gain qui sont inévitables dans un modulateur sigma-delta,
- elle n'exige aucune autre ressource matérielle supplémentaire que celles dédiées déjà à la reconstruction numérique (filtre en peigne notamment),
- elle est rapide et assure une convergence vers une bonne estimation en moins de 10 coups d'horloge de processeur.

On décrit maintenant la correction d'une disparité de gains entre différentes voies. Auparavant, on présente ici les effets d'une telle disparité, en d'autres termes l'influence des erreurs de gain dans une structure à entrelacement temporel.

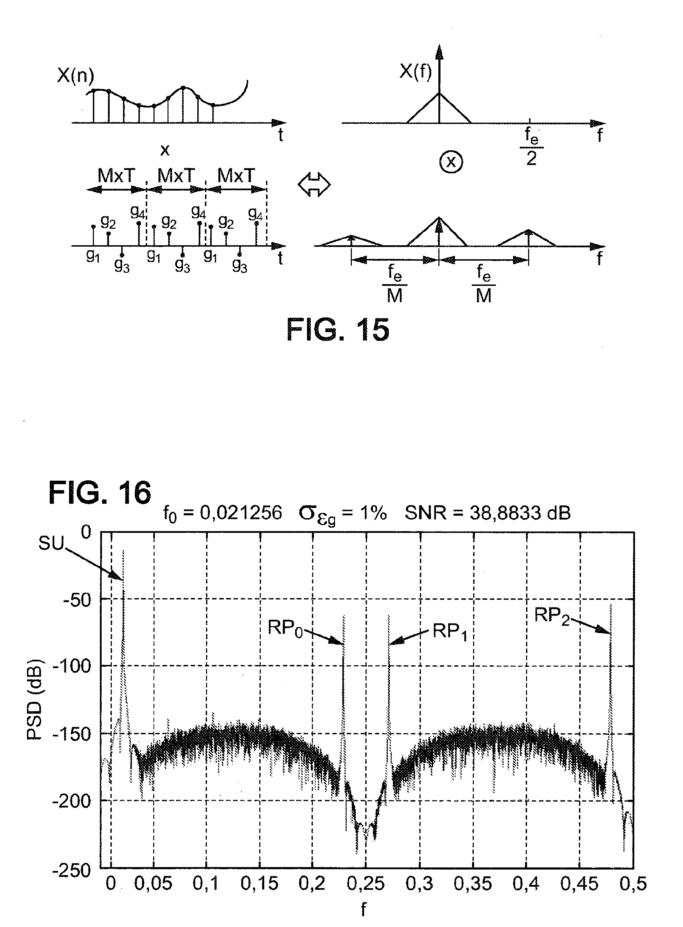

La multiplication par un gain $g_i$ à la sortie de chaque modulateur sur chaque voie $i$ de l'architecture à entrelacement temporel est équivalente à la multiplication du signal utile par un signal périodique de période $M$ formé par les différents gains $g_i$, comme illustré sur la figure 15 (à gauche, dans le domaine temporel et à droite dans le domaine fréquentiel). Cette multiplication par un signal périodique dans le domaine temporel se traduit, dans le domaine fréquentiel, par une convolution entre le spectre du signal utile et le spectre du signal périodique composé de pics Dirac situés aux fréquences $\dfrac{k}{f_e}$ (où $k$ est un entier), dont les amplitudes dépendent de l'ensemble des gains $g_i$ introduits sur les différentes voies. Cette convolution implique l'apparition, dans le spectre du signal en sortie, de répliques du spectre du signal utile aux fréquences $\left.\dfrac{kf_e}{M}\right|_{k=0...M}$ pondérées par le gain des raies spectrales du signal périodique.

La figure 16 présente la densité spectrale du signal utile SU en sortie, avec toutefois un gain $g_i$ introduit sur chaque voie (égal à $(1 + \varepsilon g)$, où $\varepsilon g$ est une variable aléatoire gaussienne de moyenne nulle et d'écart-type $\sigma_g$ =1%) qui s'applique à des répliques parasites $RP_0$, $RP_1$, $RP_2$ du signal utile, du fait de la disparité des gains. Avec une erreur de 1% sur le gain idéal de chaque voie, une chute du rapport SNR de 60 dB peut être notée. Il est donc proposé ici de corriger ces erreurs pour pouvoir maintenir les performances attendues par l'architecture à entrelacement temporel.

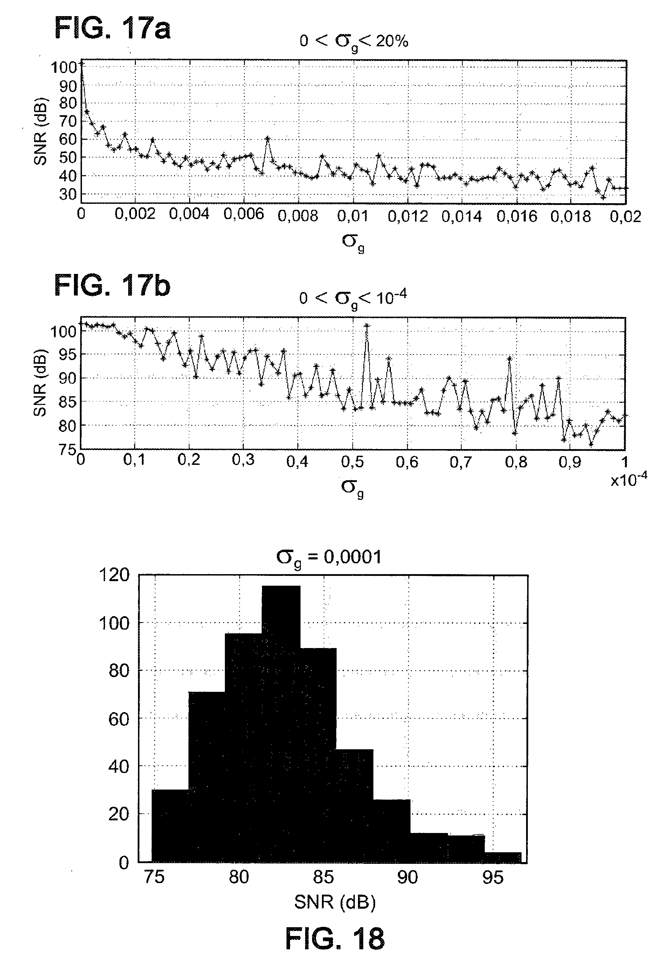

Afin de déterminer l'erreur relative maximale entre les voies, en vue d'éviter une trop grande diminution du rapport SNR, le rapport SNR a été calculé en fonction de l'écart-type de l'erreur de gain ajouté sur chaque voie. Le résultat obtenu est illustré sur les figures 17a (avec une variation rapide de l'écart-type) et 17b (avec une variation plus lente de l'écart-type). Il est notable, sur la figure 17b, que le rapport SNR est maintenu pour une erreur aléatoire dont la valeur de l'écart-type $\sigma_g$ est inférieure à $10^{-5}$, ce qui explique la forte sensibilité de l'architecture à entrelacement temporel aux erreurs de désappariement de gain. Une erreur d'écart-type plus grande, par exemple $\sigma_g$ =$10^{-4}$, entraîne déjà une chute de 30 dB du rapport SNR. Pour déterminer l'intervalle de variation du rapport SNR, des simulations de Monte-Carlo de 500 tirages ont été menées. La figure 18 présente l'histogramme des valeurs obtenues du rapport SNR. Une chute moyenne du rapport SNR de 30 dB (à 82 dB), avec un écart-type de 4 dB, est notable.

La correction de ces erreurs de gain s'effectue préférentiellement par la multiplication du signal en sortie de chaque voie par un poids $w_i$ égal à l'inverse de gain $w_i = \dfrac{1}{g_i}$. Avant de procéder à la correction de ces erreurs, il est préférable de déterminer la précision requise sur les poids $w_i$. A cet effet, le rapport SNR a été calculé en introduisant une erreur relative sur la valeur estimée définie par :

$$valeur\_estimée = valeur\_théorique \times (1 + \varepsilon),$$

où $\varepsilon$ est l'erreur relative entre la valeur estimée et la valeur théorique du poids $w_i$.

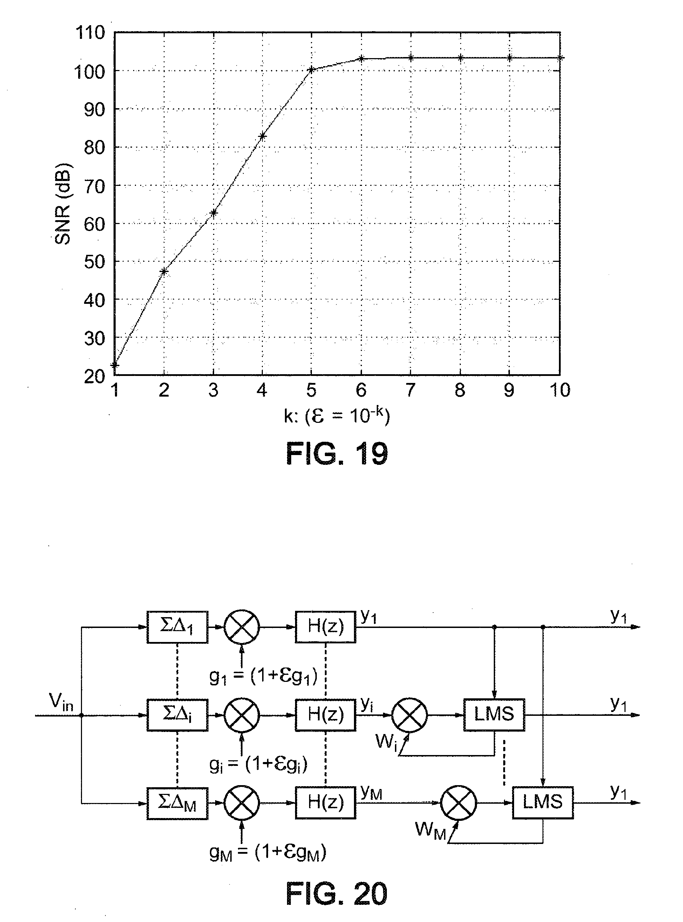

La figure 19 présente l'évolution du rapport SNR en fonction de l'erreur relative $\varepsilon$. Elle montre qu'une précision de l'ordre de $10^{-6}$ est préférable pour assurer une bonne correction des erreurs de gain et pouvoir maintenir le rapport SNR pratiquement idéal, prévu dans l'architecture à entrelacement temporel. On obtient, là aussi, la précision sur les valeurs de poids en fonction de la résolution globale **n** du convertisseur, comme suit :

$$SNR = 17,38 \times k + 13,23$$

La précision sur l'estimation de gain doit donc être égale à :

$$précision = 10^{-k} = 10^{-\left(\frac{SNR-13,23}{17,38}\right)}$$

Le rapport SNR étant fonction du nombre $n$ de bits équivalents (résolution) du convertisseur, le rapport SNR est donné par $SNR = 6,02.n + 1,76$, et la précision sur les valeurs estimées de gain s'exprime par :

$$précision = 10^{-k} = 10^{-(0,35.n-0,66)}$$

Pour corriger les effets de la disparité entre les gains des différents modulateurs, il est proposé ici une nouvelle technique basée sur le principe d'égalisation des gains entre les différentes voies. Il est préférable toutefois d'appliquer auparavant une compensation des erreurs d'offset. Cette technique présente, par rapport à d'autres techniques de l'art antérieur, les avantages suivants :

- elle ne nécessite aucun signal de référence,
- elle ne nécessite aucun modulateur supplémentaire,
- elle utilise simplement un accumulateur et un multiplieur en plus du traitement numérique existant déjà pour la reconstruction du signal utile.

En référence à la figure 20, on mène préférentiellement les étapes suivantes :

- on applique un signal d'entrée continu $V_{in}$ à tous les modulateurs, en même temps :

    l'amplitude de ce signal constant est fixée dans l'exemple décrit à une valeur $\dfrac{V_{ref}}{2}$ où $V_{ref}$ désigne la référence du circuit (d'autres valeurs pouvant être choisies à condition que les amplitudes choisies ne rendent pas le modulateur instable),

- le signal en sortie du modulateur est formé du signal constant en entrée multiplié par le gain du modulateur $g_i$ plus le bruit de quantification mis en forme (l'offset du modulateur n'entrant pas en jeu car il est supposé avoir été déjà corrigé préalablement),
- le filtre en peigne $H(z)$ permet de récupérer le signal $V_{in} \times g_i$ en sortie de chaque voie,
- on applique un traitement selon l'algorithme des Moindres Carrés Moyens (ou gradient stochastique), référencé LMS (pour « Least Mean Square »), pour calculer les différentes valeurs des poids $w_i$ visant à égaliser le gain de toutes les voies par rapport à une voie de référence.

Dans l'exemple de la figure 20, la première voie est choisie ici comme voie de référence, de sorte que :

$$g_i \times w_i = g_1\big|_{i=2...M}$$

L'algorithme LMS et ses variantes telles que celles notées :

- « SD-LMS », pour « Sign Data LMS »,
- « SE-LMS » pour « Sign Error LMS »,
- « SS-LMS » pour « Sign data Sign Error LMS »

offrent une grande simplicité de réalisation par rapport à d'autres types d'algorithmes d'estimation.

L'estimation de la valeur de poids $w_i$ par ces algorithmes est régie par les équations récurrentes suivantes :

LMS : $\hat{w}_i[n+1] = \hat{w}[n] + \mu(y_1[n] - y_i[n]) \times y[n]$
SD-LMS : $\hat{w}_i[n+1] = \hat{w}_i[n] + \mu(y_1[n] - y_i[n]) \times \text{sgn}[y_i[n]]$
SE-LMS : $\hat{w}_i[n+1] = \hat{w}_i[n] + \mu\,\text{sgn}[(y_1[n] - y_i[n])] \times y_i[n]$
SS-LMS : $\hat{w}_i[n+1] = \hat{w}_i[n] + \mu\,\text{sgn}[(y_1[n] - y_i[n])] \times \text{sgn}[y_i[n]]$

Ces quatre types d'algorithmes ont été testés et comparés en fonction du temps de convergence et de la précision sur les valeurs estimées. Dans la suite, seuls les résultats obtenus avec l'algorithme SD-LMS sont présentés pour expliquer le principe de fonctionnement et évaluer la performance de la mise en oeuvre de l'invention. Les performances obtenues avec les autres techniques seront présentées dans un tableau récapitulatif ci-après (« Tableau I »).

Pour illustrer le principe de fonctionnement de cette mise en oeuvre, les gains [1,0113 ; 1,0146 ; 1.0029 ; 0,9884] ont été introduits sur les voies respectives.

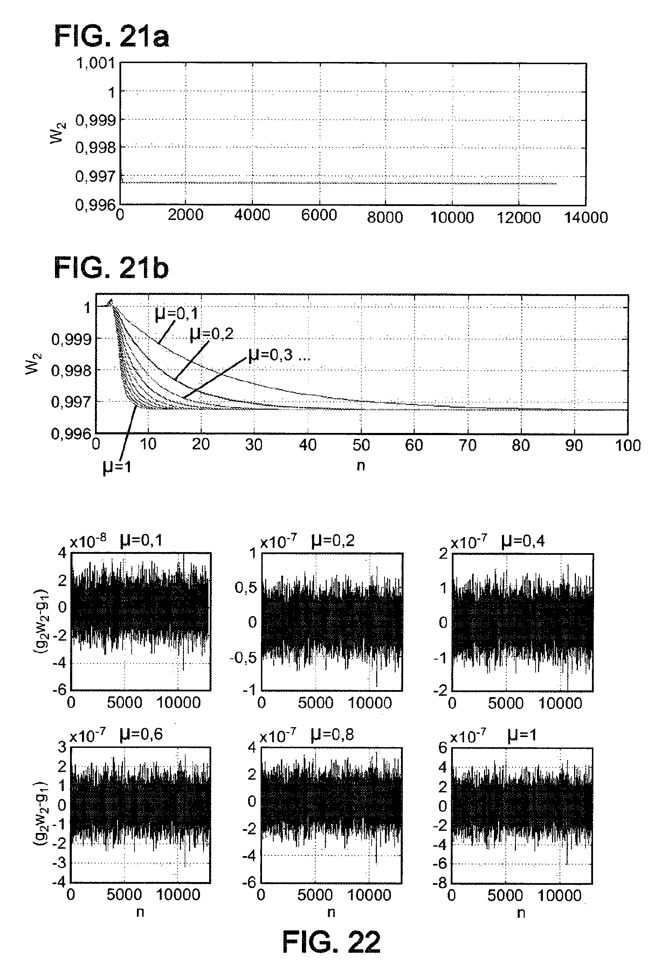

L'un des paramètres qui détermine la vitesse de convergence et la précision de l'algorithme est le pas de l'algorithme $\mu$. Pour déterminer la valeur optimale du pas $\mu$, le poids $w_2$ de la deuxième voie est estimé avec différentes

valeurs du pas $\mu$. Le résultat obtenu est illustré sur les figures 21 a et 21b.

Il apparaît que plus on augmente la valeur du pas $\mu$, plus la vitesse de convergence de l'estimation est élevée. Toutefois, il convient aussi d'étudier le comportement de la précision sur la valeur estimée en fonction du pas $\mu$. Pour chaque valeur du pas $\mu$, l'erreur entre la valeur estimée et la valeur théorique ($w_2 g_2 - g_1$) a été calculée après que la convergence soit atteinte. Les résultats obtenus sont illustrés sur la figure 22, pour différentes valeurs du pas $\mu$.

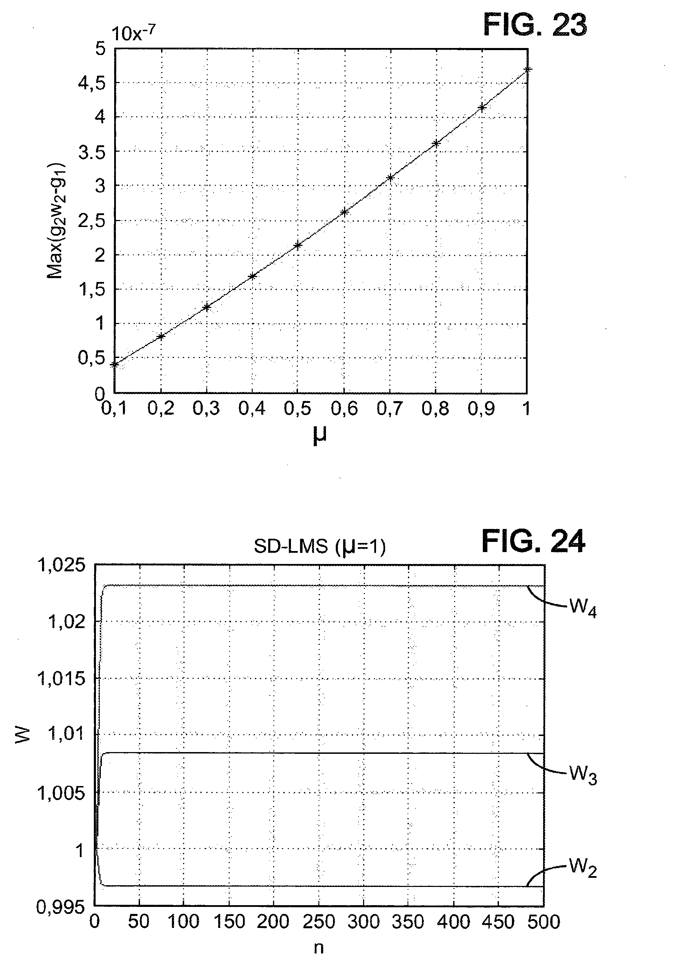

La figure 23 présente alors la valeur maximale de l'erreur obtenue en fonction du pas $\mu$. Plus on augmente la valeur du pas $\mu$, plus on augmente l'erreur sur la valeur estimée du poids $w_2$. Un choix optimal du pas de convergence $\mu$, dans le cas décrit ici à titre d'exemple, est $\mu = 1$. Ce choix permet en outre de simplifier l'algorithme en supprimant l'opération de multiplication (par un facteur autre que l'unité, sinon), tout en assurant une bonne précision d'estimation de l'ordre de $5 \times 10^{-7}$, comme le montre la figure 23.

La figure 24 présente alors l'évolution de l'estimation des valeurs de poids des différentes voies ($w_2$, $w_3$, $w_4$, la voie d'indice $i$=1 étant celle de référence) en fonction du nombre d'opérations de calcul (donc en fonction du temps de calcul d'un processeur) avec l'algorithme SD-LMS avec un pas $\mu = 1$. La convergence est assurée rapidement (au bout de n=20 coups d'horloge du processeur). Le résultat de la multiplication des valeurs de poids de chaque voie par la valeur de gain correspondant est bien égale à la valeur de gain de la première voie utilisée comme voie de référence : soit 1,0113.

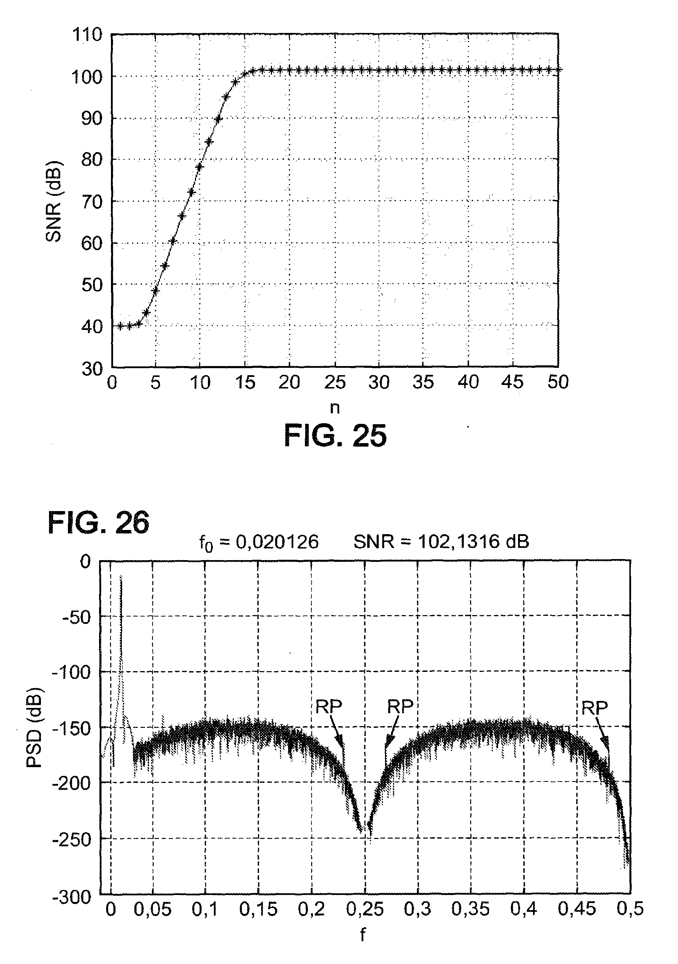

En variante, il est possible d'estimer la vitesse de convergence en calculant le rapport SNR en sortie à chaque estimation du vecteur de poids [$w_2$, $w_3$, $w_4$] en fonction du temps. Le résultat obtenu est illustré sur la figure 25. Une bonne estimation du vecteur de poids permettant de retrouver le rapport SNR souhaité est assurée au bout de n=20 coups d'horloge (n=16 étant déjà satisfaisant).

La figure 26 présente la densité spectrale du signal en sortie après la correction des erreurs de gain avec des poids estimés au bout de 20 coups d'horloge. Il apparait une nette diminution des raies parasites RP jusqu'au niveau du bruit de quantification permettant de retrouver un rapport SNR de 102 dB.

Il est présenté ci-après un cas pratique de traitement simultané, au sens de l'invention, d'erreurs d'appariement de gain et d'offset à la fois. Dans ce contexte, il a été ajouté sur chaque voie les valeurs d'offset et de gain comme suit :

$$O = \left[ -0,202\,;\,0,717\,;\,0,765\,;\,0,1832 \right] \times 10^{-4}$$

$$g = \left[ 1,0113\,;\,1,0146\,;\,1,0029\,;\,0,9884 \right]$$

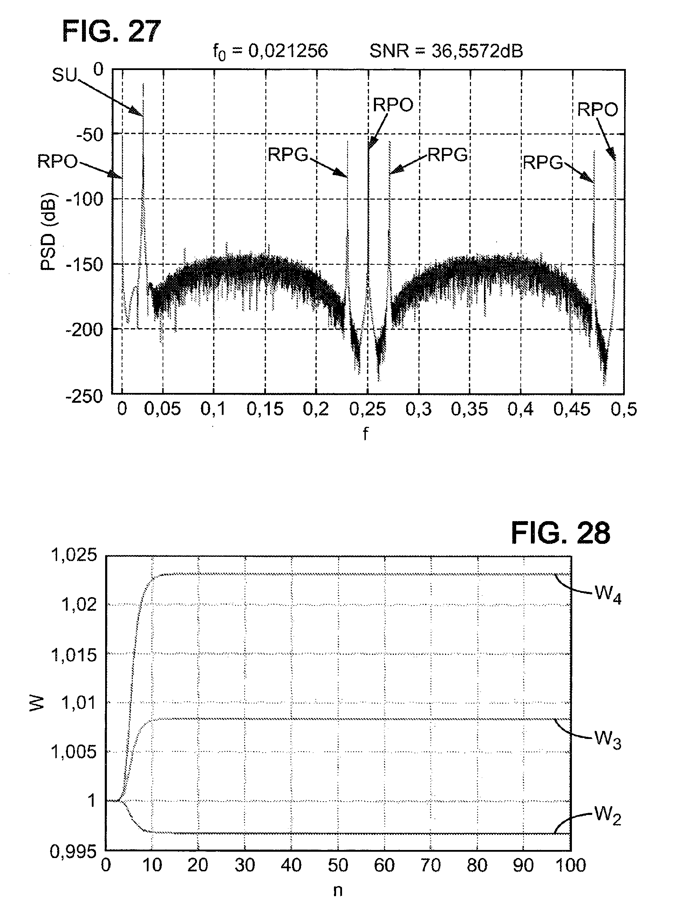

La densité spectrale du signal en sortie (avec du signal utile SU), en considérant les erreurs de gain (raies RPG) et d'offset (raies RPO), est représentée sur la figure 27. La valeur de ces erreurs entraîne au total une chute de 75 dB du rapport SNR.

La première phase de correction est la compensation de l'offset sur chaque voie. Elle est préférentiellement menée en reliant l'entrée des différents modulateurs à la masse pour pouvoir estimer l'offset de chacun de ces modulateurs. Après la compensation d'offset, la deuxième phase consiste à appliquer une tension constante à l'entrée des modulateurs pour pouvoir estimer la valeur de poids de chaque voie, permettant d'égaliser les gains de toutes les voies par rapport à la voie de référence. Dans cette phase, l'estimation du vecteur de poids par l'algorithme LMS tient compte de l'offset résiduel après la correction sur chaque voie, comme représenté sur la figure 28. L'erreur maximale sur les valeurs estimées est de $2 \times 10^{-7}$.

La figure 29 présente la densité spectrale après la correction des offsets et l'égalisation des erreurs de gain. On observe une diminution considérable des raies parasites permettant de retrouver le rapport SNR attendu.

Pour une mise en oeuvre pratique de ce procédé de correction, il peut être avantageux de déterminer la taille des registres mémoires (buffers) dans lesquels sont stockées les valeurs de poids $w$, ainsi que la taille des registres aux différentes étapes de calcul dans l'architecture de l'algorithme LMS. Dans le but de déterminer la taille optimale des registres pour optimiser les ressources de calcul et la vitesse d'exécution du procédé de correction de gain, on détermine tout d'abord le nombre de bits nécessaires pour quantifier les valeurs de poids sans craindre une chute des performances. Pour ce faire, le rapport SNR en sortie est calculé en fonction du nombre de bits de quantification *Nbw* des valeurs du poids $w$, selon la relation suivante :

$$w_q = \frac{\left| w \times 2^{Nbw} \right|}{2^{Nbw}}$$

où $w_q$ est la valeur quantifiée et $\lceil \rceil$ est l'opérateur d'arrondi.

La figure 30 présente le rapport SNR en sortie, en fonction du nombre de bits de quantification des valeurs du poids. Une quantification des valeurs de poids w sur 16 bits semble suffisante pour maintenir le rapport SNR souhaité. Afin de tenir compte de la taille finie des registres dans l'algorithme de calcul des valeurs de poids, on applique la version quantifié de l'algorithme LMS donnée par :

$$\hat{w}_{qi}[n+1] = \left\langle \hat{w}_{qi}[n] + \mu \left( \left\langle y_1[n] \right\rangle_{Nbr} - \left\langle y_i[n] \right\rangle_{Nbr} \right) \times \left\langle y_i[n] \right\rangle_{Nbr} \right\rangle_{Nbw}$$

L'opérateur $\langle \ \rangle_{Nb}$ représente la quantification de la valeur entre crochet sur $Nb$ bits. Il est donné par :

$$A_q = \frac{\left\lfloor A \times 2^{Nb} \right\rfloor}{2^{Nb}}$$

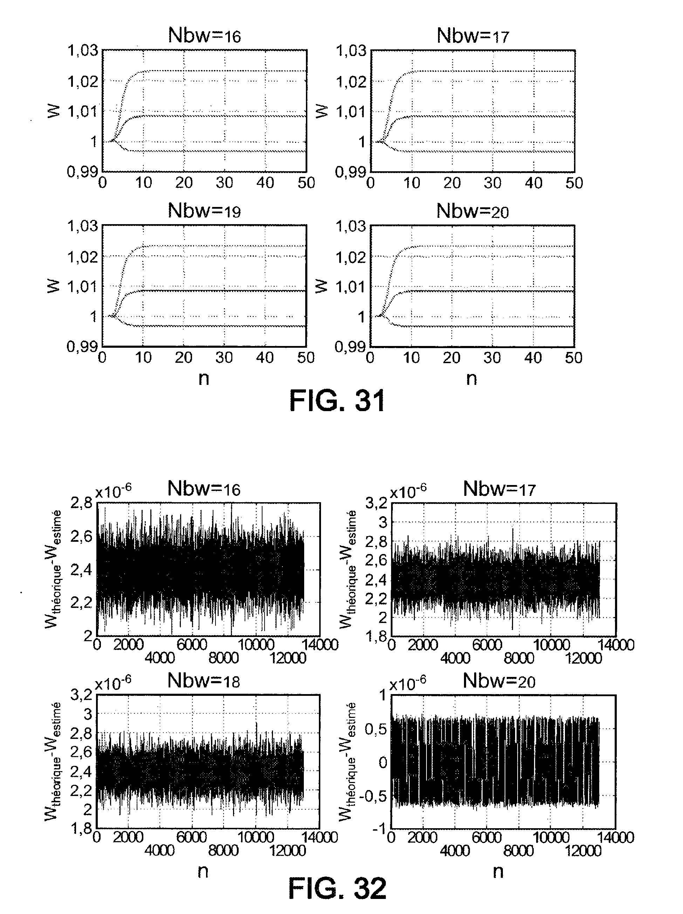

$Nbr$ désigne la longueur du mot binaire à la sortie du filtre numérique $H(z)$, fixé à 25 bits dans l'exemple décrit. Afin de déterminer le nombre optimal de bits $Nbw$, les valeurs de poids w sont estimées par l'algorithme SD-LMS en tenant compte de l'effet de quantification. La figure 31 présente l'évolution de l'estimation en fonction du temps pour différentes valeurs du nombre $Nbw$ (16, 17, 19 et 20). On constate que la quantification des valeurs de poids w n'influe pas sur la vitesse de convergence. L'influence du nombre $Nbw$ sur la précision des valeurs estimés est illustrée sur la figure 32 montrant la différence entre la valeur estimée et la valeur théorique du poids à estimer en fonction du temps de calcul n et pour différentes valeurs du nombre $Nbw$ (16, 17, 18 et 20). Plus on augmente le nombre $Nbw$, plus on diminue l'erreur d'estimation. Une quantification des valeurs du poids sur 20 bits apparait alors suffisante pour pouvoir assurer une précision de l'ordre de $6 \times 10^{-7}$ et maintenir la performance souhaitée. On peut constater en pratique que le nombre $Nbw$ optimal est lié, en fait, à la résolution du convertisseur (notée n et égale à 16 ici). Il s'avère qu'il est généralement avantageux que le nombre de bits $Nbw$ soit compris entre n et n+4, préférentiellement entre n+1 et n+4.

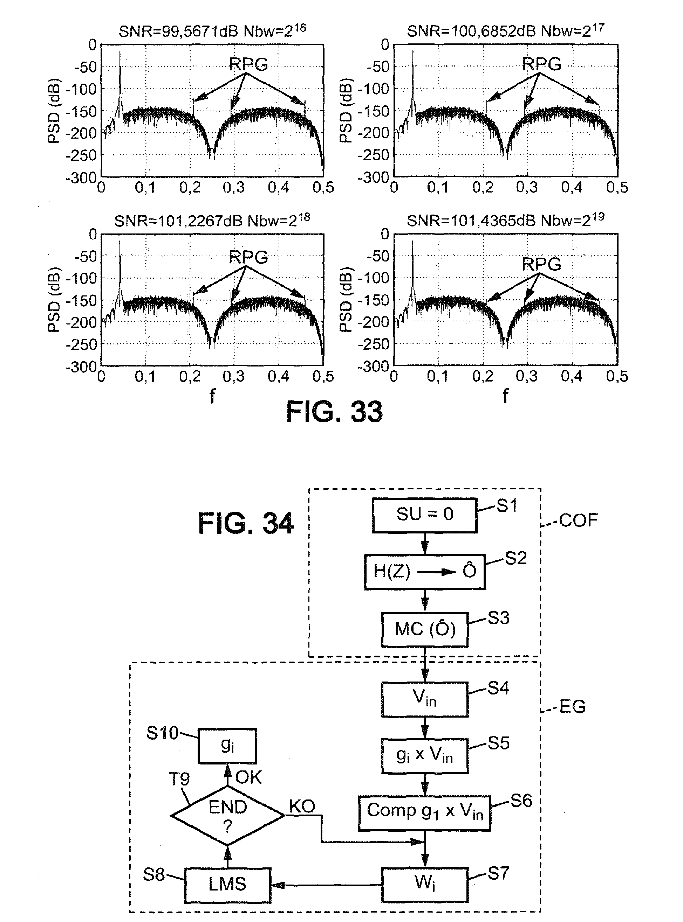

Pour illustrer l'effet du nombre $Nbw$, la figure 33 présente la densité spectrale du signal en sortie avec l'égalisation des gains avec des valeurs de poids w estimées avec des nombres $Nbw$ différents. Plus on augmente le nombre $Nbw$, plus on diminue l'amplitude des raies parasites RPG et on améliore alors le rapport SNR. Une valeur du nombre $Nbw$ égale à 20 est suffisante pour pouvoir maintenir le rapport SNR souhaité.

Les résultats de l'estimation des valeurs de poids étudiée avec d'autres types d'algorithmes de la famille des Moindres Carrés LMS sont récapitulés dans le Tableau 1 ci-après. Le tableau présente en particulier les ressources matérielles et la vitesse de convergence pour ces différents types de traitement.

**Tableau 1 : Récapitulatif des ressources matérielles nécessaires aux différents types d'algorithmes de traitement au sens des Moindres Carrés Moyens LMS.**

| Algorithme | $\mu$ | Multiplications | Additions | Temps de convergence | $Nbw$ |
|---|---|---|---|---|---|
| LMS | 1 | 1 | 2 | $Tc = 35 \dfrac{N}{f_{op}}$ | 18 |
| SD-LMS | 1 | 0 | 2 | $Tc = 20 \dfrac{N}{f_{op}}$ | 17 |
| SE-LMS | $\dfrac{1}{2^{16}}$ | 1 (décalage) | 2 | $Tc = 780 \dfrac{N}{f_{op}}$ | 17 |
| SS-LMS | $\dfrac{1}{2^{16}}$ | 0 | 2 | $Tc = 1550 \dfrac{N}{f_{op}}$ | 17 |

Bien que les algorithmes SE-LMS et SS-LMS offrent une grande facilité d'implémentation par rapport aux algorithmes LMS et SD-LMS, ils présentent un temps de convergence plus élevé. Il apparait que l'algorithme permettant un bon compromis entre complexité matérielle et temps de convergence est l'algorithme SD-LMS. Ce type d'algorithme, avec le pas μ=1, ne nécessite pas de multiplicateur et seul un accumulateur pour réaliser les additions est à ajouter sur chaque voie, par rapport à la structure classique d'une architecture multivoies à entrelacement temporel d'un convertisseur.

On se réfère maintenant à la figure 34 pour résumer un traitement global au sens de l'invention.

Le traitement commence par la compensation d'offset COF, laquelle comporte préférentiellement les étapes :

- appliquer un signal nul en entrée du convertisseur pour obtenir l'offset seul en sortie à l'étape S1,
- utiliser le filtrage numérique $H(z)$ pour estimer une valeur d'offset pour chaque voie à l'étape S2, et
- compenser la valeur estimée de l'offset sur chaque voie, en faisant intervenir des moyens de compensation MC à l'étape S3.

Le traitement se poursuit par l'égalisation de gains EG, dans laquelle :

- on applique un même signal Vin, constant, à chaque voie (étape S4),
- on récupère un signal de sortie correspondant à un produit de ce même signal par un gain $g_i$ propre à chaque voie, à l'étape S5, et
- on compare le produit de chaque voie au produit d'une voie de référence (étape S6) pour en déduire, pour chaque voie, l'estimation d'un poids d'égalisation de gain $w_i$ par rapport à la voie de référence (étape S7).

L'estimation du poids pour une voie est menée en appliquant préférentiellement un traitement itératif, au sens des moindres carrés moyens LMS (étape S8), et préférentiellement de type SD-LMS ne nécessitant alors que l'ajout d'un simple accumulateur (référence LMS de la figure 20) dans chaque voie de l'architecture à entrelacement temporel. Le traitement itératif est mené jusqu'à ce que la différence de poids entre deux itérations consécutives devienne inférieure à la précision désirée (flèche OK en sortie du test T9). On procède ensuite à l'égalisation des gains $g_i$ en fonction des poids $w_i$ estimés (étape S10).

La figure 34 peut alors illustrer à titre d'exemple un organigramme général du programme informatique au sens de l'invention.

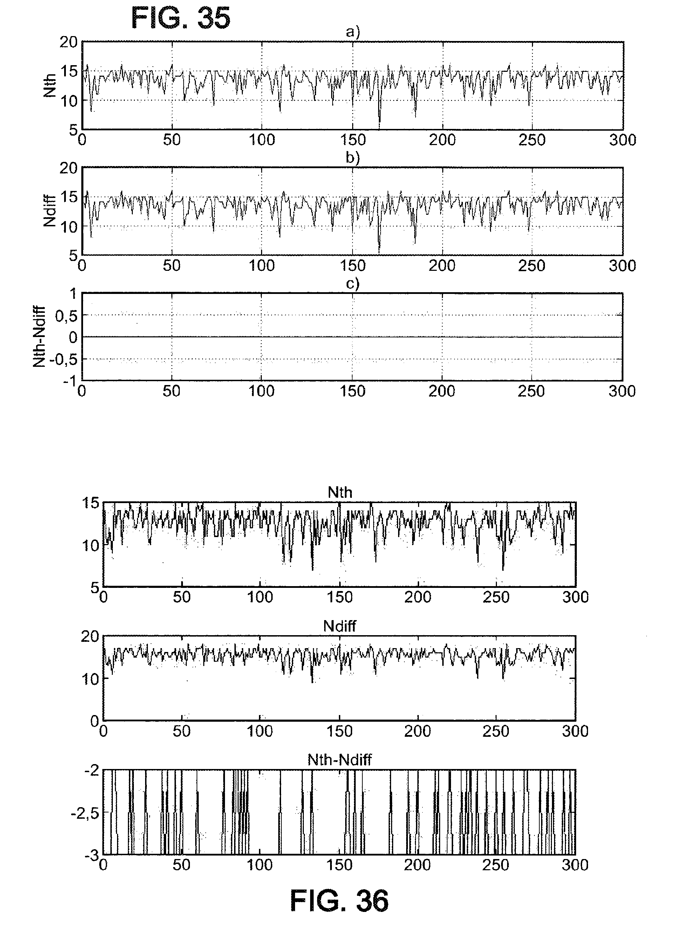

On précise ci-après les conditions d'arrêt du traitement itératif SD-LMS (au test T9). En théorie, il doit s'arrêter lorsque la différence entre la valeur estimée du poids $\hat{w}_i[n+1]$ et sa valeur théorique $w_i^{th}$ devient inférieure à la précision requise. Dans ce cas, la convergence est assurée. Toutefois, la valeur théorique $w_i^{th}$ est inconnue. Il est proposé alors ici d'arrêter le traitement itératif quand la différence entre deux estimations successives de poids ($\hat{w}_i[n+1]-\hat{w}_i[n]$) est inférieure à la précision désirée. Ce calcul de la différence revient à filtrer les valeurs estimées par l'algorithme SD-LMS (notées $\hat{w}_i[n+1]$) par un filtre de fonction de transfert de type ($1-z^{-1}$). En pratique, il convient de ne pas tenir compte des deux premières sorties de ce filtre qui représentent la réponse transitoire du filtre. La figure 35 montre les nombres d'itérations *Nth* et *Ndiff* obtenus respectivement avec un calcul théorique et le calcul de la différence, dans ce mode de réalisation, à partir d'une simulation de Monte-Carlo avec 300 tirages de valeurs de gains sur les différentes voies avec un écart-type $\sigma_g$ =1%. On remarque alors que le calcul par la différence ($\hat{w}_i[n+1] - \hat{w}_i[n]$) présente un temps de convergence identique à celui obtenu par le calcul théorique.

Il est indiqué en outre que, dans certains cas, l'évolution de la valeur estimée de poids peut ne pas être monotone et peut passer par des zones de stationnarité qui pourraient arrêter l'exécution du traitement itératif LMS avant d'atteindre pourtant la convergence. Pour éviter une telle situation, des filtres d'ordre élevé de fonction de transfert de type ($1-z^{Lf}$) peuvent être utilisés. La figure 36 présente le temps de convergence avec un filtre d'ordre 3 (*Lf* = 3). On note ici que la convergence, en utilisant un tel filtre, est assurée au maximum après *Lf* coups d'horloge par rapport à la convergence obtenue par le calcul théorique.

Bien entendu, la présente invention ne se limite pas à la forme de réalisation décrite ci-avant à titre d'exemple ; elle s'applique à d'autres variantes.

Par exemple, le procédé de correction proposé ci-avant peut être appliqué à d'autres types d'architectures parallèles de convertisseur utilisant des bancs de filtres, notamment décrites dans le document FR-08 54846.

Plus généralement, on a décrit ci-avant l'utilisation d'un filtre en peigne pour estimer l'offset et la disparité des gains. Néanmoins, dans l'exemple de réalisation décrit ci-avant, un filtre passe-bas sélectif aurait suffit.

Par ailleurs, on a décrit ci-avant une architecture à entrelacement temporel utilisant en particulier des modulateurs sigma-delta. Toutefois, l'invention s'applique bien entendu à des architectures à entrelacement temporel utilisant d'autres types de modulateurs.

**Revendications**

1. Procédé de traitement de signal, dans un convertisseur analogique/numérique comportant une architecture multivoies à entrelacement temporel, auquel on applique:

   - un filtrage numérique (H(z)) dans chaque voie au moins pour estimer une erreur d'offset du convertisseur,
   - et une compensation de l'offset en fonction de l'erreur d'offset estimée, et, le convertisseur comportant au moins un modulateur sigma-delta dans chaque voie, **caractérisé en ce que** le filtrage numérique (*H*(*z*)) est appliqué dans chaque voie à la fois pour :
   - reconstruire un signal utile issu de la conversion analogique/numérique, et
   - pour estimer l'erreur d'offset.

2. Procédé selon la revendication 1, **caractérisé en ce que** la compensation d'offset comporte les étapes :

   - appliquer un signal nul en entrée du convertisseur pour obtenir l'offset seul en sortie (S1),
   - utiliser le filtrage numérique pour estimer une valeur d'offset pour chaque voie (S2), et
   - compenser la valeur estimée de l'offset sur chaque voie (S3).

3. Procédé selon l'une des revendications précédentes, **caractérisé en ce que** l'estimation de l'erreur d'offset est menée par un filtrage passe-bas numérique sélectif.

4. Procédé selon la revendication 3, **caractérisé en ce que** le filtrage est appliqué par un filtre en peigne (*H*(*z*)) dans chaque voie.

5. Procédé selon l'une des revendications 3 et 4, **caractérisé en ce que** l'erreur d'offset est estimée à une précision inférieure à $10^{-(0.3n+1.9)}$, où *n* est la résolution, en nombre de bits, du convertisseur.

6. Procédé selon l'une des revendications précédentes, **caractérisé en ce que** le filtrage numérique est appliqué en outre pour une égalisation de gains (EG) entre les différentes voies de l'architecture multivoies, après compensation de l'offset (COF).

7. Procédé selon la revendication 6, **caractérisé en ce que** :

   - on applique un même signal, constant, à chaque voie (S4),
   - on récupère un signal de sortie correspondant à un produit dudit même signal par un gain propre à chaque voie (S5),
   - on compare (S6) le produit de chaque voie au produit d'une voie de référence pour en déduire (S7), pour chaque voie, l'estimation d'un poids d'égalisation de gain par rapport à la voie de référence.

8. Procédé selon la revendication 7, **caractérisé en ce que** l'estimation du poids pour une voie est menée en appliquant un traitement itératif (S8), au sens des moindres carrés moyens.

9. Procédé selon la revendication 8, **caractérisé en ce que** le traitement suit une relation du type $\hat{w}_i[n+1] = \hat{w}_i[n] + \mu f_i[n]$, où:

   - $\hat{w}_i[n+1]$ et $\hat{w}_i[n]$ sont les estimations du poids pour une voie *i,* aux itérations respectives n+1 et n,
   - $\mu$ est une constante,
   - $f_i[n]$ est le produit :

     • entre la différence des signaux de sortie de la voie de référence et de la voie *i* et le signe du signal de sortie de la voie *i*,
     • ou entre le signal de sortie de la voie *i* et le signe de la différence des signaux de sortie de la voie de référence et de la voie *i*,
     • ou entre le signal de sortie de la voie *i* et la différence des signaux de sortie de la voie de référence et de la voie *i*,

• ou entre le signe du signal de sortie de la voie *i* et le signe de la différence des signaux de sortie de la voie de référence et de la voie *i*.

10. Procédé selon la revendication 9, **caractérisé en ce que** le traitement suit une relation du type :

$$\hat{w}_i\left[n+1\right] = \hat{w}_i\left[n\right] + \mu\left(y_{ref}\left[n\right] - y_i\left[n\right]\right) \times \mathrm{sgn}\left(y_i\left[n\right]\right),$$

où :

- $y_{ref}[n]$ et $y_i[n]$ sont les signaux de sortie respectivement de la voie de référence et de la voie *i*, et
- la notation sgn(x) désigne le signe du réel x.

11. Procédé selon l'une des revendications 6 à 10, **caractérisé en ce que** le poids d'égalisation est estimé à une précision inférieure à $10^{-(0.3n-0.65)}$, où *n* est la résolution, en nombre de bits, du convertisseur.

12. Procédé selon l'une des revendications 9 et 10, prises en combinaison avec la revendication 11, **caractérisé en ce que** la constante $\mu$ est choisie pour optimiser une vitesse de convergence du traitement itératif et atteindre ladite précision.

13. Procédé selon l'une des revendications 7 à 12, **caractérisé en ce que** les valeurs de poids à estimer sont codées sur un nombre de bits compris entre n+1 et n+4, où n est la résolution, en nombre de bits, du convertisseur.

14. Convertisseur analogique/numérique comportant une architecture multivoies à entrelacement temporel avec au moins un modulateur sigma-delta dans chaque voie, **caractérisé en ce qu'**il comporte :

- un filtre numérique dans chaque voie (*H*(*z*)), pour reconstruire un signal utile issu de la conversion analogique/numérique et estimer une erreur d'offset du convertisseur, et
- des moyens de compensation d'offset (MC) en fonction de l'erreur d'offset estimée.

15. Programme informatique comportant des instructions pour la mise en oeuvre du procédé selon l'une des revendications 1 à 13, lorsque ce programme est exécuté par un processeur.

**Patentansprüche**

1. Signalverarbeitungsverfahren in einem Analog-Digital-Wandler, der eine Mehrkanalarchitektur mit Zeitverschachtelung aufweist, an den angewendet wird:

- eine digitale Filterung (H(z)) in mindestens jedem Kanal, um einen Offsetfehler des Wandlers zu schätzen,
- und eine Kompensation des Offsets abhängig vom geschätzten Offsetfehler,
und wobei der Wandler mindestens einen Sigma-Delta-Modulator in jedem Kanal aufweist,
**dadurch gekennzeichnet, dass** die digitale Filterung (H(z)) in jedem Kanal angewendet wird, um gleichzeitig:
- ein aus der Analog-Digital-Umwandlung stammendes Nutzsignal zu rekonstruieren, und
- den Offsetfehler zu schätzen.

2. Verfahren nach Anspruch 1, **dadurch gekennzeichnet, dass** die Offsetkompensation die folgenden Schritte aufweist:

- Anlegen eines Null-Signals an den Eingang des Wandlers, um nur den Offset am Ausgang zu erhalten (S1),
- Verwenden der digitalen Filterung, um einen Offsetwert für jeden Kanal zu schätzen (S2), und
- Kompensieren des geschätzten Werts des Offsets in jedem Kanal (S3).

3. Verfahren nach einem der vorhergehenden Ansprüche, **dadurch gekennzeichnet, dass** die Schätzung des Offsetfehlers durch eine selektive digitale Tiefpassfilterung durchgeführt wird.

4. Verfahren nach Anspruch 3, **dadurch gekennzeichnet, dass** die Filterung durch ein Kammfilter (H(z)) in jedem Kanal angewendet wird.

5. Verfahren nach einem der Ansprüche 3 und 4, **dadurch gekennzeichnet, dass** der Offsetfehler mit einer Präzision geringer als $10^{-(0.3n+1.9)}$ geschätzt wird, wobei n die Auflösung, in Anzahl von Bits, des Wandlers ist.

6. Verfahren nach einem der vorhergehenden Ansprüche, **dadurch gekennzeichnet, dass** die digitale Filterung außerdem für eine Verstärkungsentzerrung (EG) zwischen den verschiedenen Kanälen der Mehrkanalarchitektur nach der Kompensation des Offsets (COF) angewendet wird.

7. Verfahren nach Anspruch 6, **dadurch gekennzeichnet, dass**:

- ein gleiches konstantes Signal an jeden Kanal (S4) angelegt wird,
- ein Ausgangssignal entsprechend einem Produkt aus dem gleichen Signal und einer jedem Kanal eigenen Verstärkung wiedergewonnen wird (S5),
- das Produkt jedes Kanals mit dem Produkt eines Bezugskanals verglichen wird (S6), um daraus für jeden Kanal die Schätzung eines Verstärkungsentzerrungsgewichts bezüglich des Bezugskanals abzuleiten (S7).

8. Verfahren nach Anspruch 7, **dadurch gekennzeichnet, dass** die Schätzung des Gewichts für einen Kanal durchgeführt wird, indem eine iterative Verarbeitung im Sinne der Least Mean Squares angewendet wird (S8).

9. Verfahren nach Anspruch 8, **dadurch gekennzeichnet, dass** die Verarbeitung einer Beziehung der Art $\hat{w}_i[n+1] = \hat{w}_i[n] + \mu f_i[n]$ folgt, wobei:

- $\hat{w}_i[n+1]$ und $\hat{w}_i[n]$ die Schätzungen des Gewichts für einen Kanal i bei den Iterationen n+1 bzw. n sind,
- p eine Konstante ist,
- $f_i[n]$ das Produkt ist:

• aus der Differenz der Ausgangssignale des Bezugskanals und des Kanals i und dem Vorzeichen des Ausgangssignals des Kanals i,
• oder aus dem Ausgangssignal des Kanals i und dem Vorzeichen der Differenz der Ausgangssignale des Bezugskanals und des Kanals i,
• oder aus dem Ausgangssignal des Kanals i und der Differenz der Ausgangssignale des Bezugskanals und des Kanals i,
• oder aus dem Vorzeichen des Ausgangssignals des Kanals i und dem Vorzeichen der Differenz der Ausgangssignale des Bezugskanals und des Kanals i.

10. Verfahren nach Anspruch 9, **dadurch gekennzeichnet, dass** die Verarbeitung einer Beziehung der Art:

$$\hat{w}_i[n+1] = \hat{w}_i[n] + \mu(y_{ref}[n]-y_i[n]) \times sgn(y_i[n])$$

folgt, wobei:

- $y_{ref}[n]$ und $y_i[n]$ die Ausgangssignale des Bezugskanals bzw. des Kanals i sind, und
- die Schreibweise sgn(x) das Vorzeichen der reellen Zahl x bezeichnet.

11. Verfahren nach einem der Ansprüche 6 bis 10, **dadurch gekennzeichnet, dass** das Entzerrungsgewicht mit einer Präzision geringer als $10^{-(0.34n-0.65)}$ geschätzt wird, wobei n die Auflösung, in Anzahl von Bits, des Wandlers ist.

12. Verfahren nach einem der Ansprüche 9 und 10 in Kombination mit Anspruch 11, **dadurch gekennzeichnet, dass** die Konstante p gewählt wird, um eine Konvergenzgeschwindigkeit der iterativen Verarbeitung zu optimieren und die Präzision zu erreichen.

13. Verfahren nach einem der Ansprüche 7 bis 12, **dadurch gekennzeichnet, dass** die zu schätzenden Gewichtswerte auf eine Anzahl von Bits zwischen n+1 und n+4 codiert sind, wobei n die Auflösung, in Anzahl von Bits, des Wandlers ist.

**14.** Analog-Digital-Wandler, der eine Mehrkanalarchitektur mit Zeitverschachtelung mit mindestens einem Sigma-Delta-Modulator in jedem Kanal aufweist, **dadurch gekennzeichnet, dass** er aufweist:

- ein digitales Filter in jedem Kanal (H(z)), um ein aus der Analog-Digital-Umwandlung stammendes Nutzsignal zu rekonstruieren und einen Offsetfehler des Wandlers zu schätzen, und
- Einrichtungen zur Offsetkompensation (MC) abhängig vom geschätzten Offsetfehler.

**15.** EDV-Programm, das Anweisungen zur Durchführung des Verfahrens nach einem der Ansprüche 1 bis 13 aufweist, wenn dieses Programm von einem Prozessor ausgeführt wird.

**Claims**

**1.** Method for processing a signal, in an analog-to-digital converter comprising a multi-channel time-interleaved architecture, to which is applied:

- a digital filtering ($H(z)$) in each channel for at least estimating an offset error of the converter,
- and a compensation for the offset as a function of the estimated offset error.
said converter comprising at least one sigma-delta modulator in each channel, **characterized in that** the digital filtering ($H(z)$) is applied in each channel in order to both:
- reconstruct a useful signal issuing from the analog-to-digital conversion, and
- estimate the offset error.

**2.** Method according to claim 1, wherein the offset compensation comprises the steps of:

- applying a null signal as input to the converter in order to obtain the offset alone as output (S1),
- using the digital filtering to estimate an offset value for each channel (S2), and
- compensating for the estimated value of the offset on each channel (S3).

**3.** Method according to any one of the preceding claims, wherein the estimation of the offset error is performed by selective digital low-pass filtering.

**4.** Method according to claim 3, wherein the filtering is applied by a comb filter ($H(z)$) in each channel.

**5.** Method according to either of claims 3 or 4, wherein the offset error is estimated at a precision of less than $10^{-(0.3n+1.9)}$, where $n$ is the resolution, in number of bits, of the converter.

**6.** Method according to any one of the above claims, wherein the digital filtering is additionally applied to equalize the gain (EG) across the different channels of the multi-channel architecture, after compensation for the offset (COF).

**7.** Method according to claim 6, wherein:

- a same constant signal is applied to each channel (S4),
- an output signal is collected, corresponding to a product of said same signal and a gain specific to each channel (S5),
- the product from each channel is compared to the product from a reference channel (S6) in order to estimate (S7), for each channel, a gain equalization weight relative to the reference channel.

**8.** Method according to claim 7, wherein the weight estimation for a channel is conducted by applying iterative processing (S8) that uses least mean squares.

**9.** Method according to claim 8, wherein the processing follows a relation of the type $\hat{w}_i[n+1] = \hat{w}_i[n] + \mu f_i[n]$, where:

- $\hat{w}_i[n+1]$ and $\hat{w}_i[n]$ are estimates of the weight for a channel $i$, respectively for the iterations $n+1$ and $n$,
- $\mu$ is a constant,
- $f_i[n]$ is the product:

  • of the difference between the output signals from the reference channel and channel $i$, and the sign of the output signal from the channel *i*,
• or of the output signal from channel *i* and the sign of the difference between the output signals from the reference channel and channel *i*,
• or of the output signal from channel *i* and the difference between the output signals from the reference channel and channel *i*,
• or of the sign of the output signal from channel *i* and the sign of the difference between the output signals from the reference channel and channel *i*.

**10.** Method according to claim 9, wherein the processing follows a relation of the type:

$$\hat{w}_i\left[n+1\right]=\hat{w}_i\left[n\right]+\mu\left(y_{ref}\left[n\right]-y_i\left[n\right]\right)\times\mathrm{sgn}\left(y_i\left[n\right]\right),$$

where:

- $y_{ref}$ [*n*] and $y_i$ [*n*] are the respective output signals from the reference channel and channel *i*, and
- the notation sgn(x) indicates the sign of the real number x.

**11.** Method according to any one of claims 6 to 10, wherein the equalization weight is estimated at a precision of less than $10^{-(0.34n-0.65)}$, where *n* is the resolution, in number of bits, of the converter.

**12.** Method according to either of claims 9 or 10, taken in combination with claim 11, wherein the constant $\mu$ is chosen to optimize a rate of convergence of the iterative processing and achieve said precision.

**13.** Method according to any one of claims 7 to 12, wherein the weight values to be estimated are encoded in a number of bits of between n+1 and n+4, where n is the resolution, in number of bits, of the converter.

**14.** Analog-to-digital converter comprising a multi-channel time-interleaved architecture, wherein said converter comprises:

- a digital filter in each channel (*H*(*z*)), for reconstructing a useful signal issued from the analog-to-digital conversion and for estimating an offset error of the converter, and
- a means of compensating for the offset (MC) as a function of the estimated offset error.

**15.** Computer program comprising instructions for implementing the method according to any one of claims 1 to 13 when this program is executed by a processor.

FIG. 1

FIG. 2

$f_0 = 0{,}0212$      SNR = 102,1631 dB

# FIG. 3

$f_0 = 0,021256$    SNR = 21,5924 dB

# FIG. 4

# FIG. 5

$f_0 = 0{,}021256$      $SNR = 71{,}942$ dB      $\sigma_0 = 2e\text{-}006$

# FIG. 6

**FIG. 7**

**FIG. 8**

## FIG. 9

$\sigma = 1\%$

## FIG. 10

FIG. 11

FIG. 12

## FIG. 13

f$_0$ = 0,021256      SNR = 39,1944 dB

## FIG. 14

f$_0$ = 0,021256      SNR = 99,7868 dB

**FIG. 15**

**FIG. 16**

$f_0 = 0{,}021256$ $\quad \sigma_{\varepsilon g} = 1\%$ $\quad$ SNR = 38,8833 dB

## FIG. 17a

$0 < \sigma_g < 20\%$

## FIG. 17b

$0 < \sigma_g < 10^{-4}$

$\sigma_g = 0,0001$

## FIG. 18

**FIG. 19**

**FIG. 20**

## FIG. 21a

## FIG. 21b

## FIG. 22

FIG. 23

FIG. 24

FIG. 25

FIG. 26

$f_0 = 0,020126$     SNR = 102,1316 dB

**FIG. 27**

$f_0 = 0{,}021256$     $SNR = 36{,}5572dB$

**FIG. 28**

## FIG. 29

$f_0 = 0,020126$     SNR = 103,22dB

## FIG. 30

FIG. 31

FIG. 32

FIG. 33

FIG. 34

## FIG. 35

## FIG. 36

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 0858632
- FR 0853213
- EP 1401105 A
- FR 0854846

**Littérature non-brevet citée dans la description**

- **R. BATTEN ; A. ESHRAGHI ; T. FIEZ.** Calibration of parallel $\Sigma\Delta$ ADCs. *IEEE transactions on circuits and systems-II analog and digital signal processing,* Juin 2002, vol. 49 (6), 390-399
- **JE EKLUND ; F GUSTAFSSON.** Digital offset compensation of time-interleaved ADC using random chopper sampling. *IEEE ISCAS 2000,* Mai 2000
- **V.T. NGUYEN ; P. LOUMEAU ; J.F. NAVINER.** Advantages of high-pass $\Delta\Sigma$ modulators in interleaved $\Delta\Sigma$ analog to digital converter. *Circuits and Systems, MWSCAS-2002 (45th Midwest Symposium),* Août 2002, vol. 1 (4-7), I - 136-I - 139
- **D. FU ; K.C. DYER ; S.H. LEWIS ; P.J. HURST.** A digital background calibration techniques for time-interleaved anadog-to-digital converters. *IEEE Journal of Solid-State Circuits,* Décembre 1998
- **A. ESHRAGHI ; T. FIEZ.** A comparative analysis of parallel delta-sigma ADC architectures. *Circuits and Systems I: Regular Papers, IEEE Transactions on,* 2004, vol. 51 (3), 450-458